# EUROPEAN PATENT SPECIFICATION

(11) **EP 4 398 251 B1**
(45) Date of publication and mention of the grant of the patent: **15.10.2025**
(21) Application number: 23214026.9
(22) Date of filing: 04.12.2023
(51) Int. Cl.: G11C 11/56, G11C 16/08, G11C 16/26, G11C 16/32, G11C 16/34, G11C 16/04

(54) **NAND MEMORY DEVICE WORDLINES PRE-CHARGING AND OPERATING METHOD OF THE SAME**
NAND-SPEICHERVORRICHTUNGWORTLEITUNGENVORLADUNG UND BETRIEBSVERFAHREN DAFÜR
PRÉCHARGEMENT DE LIGNES DE MOTS DANS UNE MÉMOIRE NAND ET SON PROCÉDÉ DE FONCTIONNEMENT

(30) Priority: 03.01.2023 KR 20230000899
(43) Date of publication of application: 10.07.2024
(73) Proprietor: Samsung Electronics Co., Ltd., Suwon-si, Gyeonggi-do 16677 (KR)
(72) Inventor: LEE, Yohan, 16677 Suwon-si (KR); YU, Jaeduk, 16677 Suwon-si (KR); PARK, Sangsoo, 16677 Suwon-si (KR); PARK, Jonghoon, 16677 Suwon-si (KR)
(74) Representative: Marks & Clerk LLP

(56) References cited:
- US-A1- 2020 395 075
- US-A1- 2022 336 006

## Description

### FIELD

Aspects of the inventive concept relate to a memory device, and more particularly, to a memory device for pre-charging a common source line.

### BACKGROUND

As the degree of integration of memory increases, the number of stacked word lines may increase. As the number of word lines increases, capacitance of word lines may increase and power consumed by a charge pump to set up word lines may increase.

To improve the speed of a read operation or a verification operation, it is necessary to shorten the word line setup time.

US 2020395075 A1 discloses a semiconductor device and method of operating a semiconductor device, wherein the semiconductor device includes memory strings coupled between a common source line and a bit line, and a peripheral circuit coupled to the memory strings through a plurality of word lines and a dummy word line, and configured to set bias of the word lines and the dummy word line before performing a read operation, wherein the peripheral circuit applies a first pass voltage to the word lines concurrently with applying an initial voltage lower than the first pass voltage to the dummy word line, and increases the first pass voltage and the initial voltage to a second pass voltage to set the bias of the word lines and the dummy word line.

US 2022336006 A1 discloses that a memory having a plurality of blocks is coupled with control circuits having logic to execute a no-current read setup operation, the read setup operation comprising simultaneously applying a read setup bias to a plurality of memory cells of a selected block of the plurality of blocks while disabling current flow. Logic to traverse the blocks in the plurality of blocks can apply the read setup operation to the plurality of blocks. The blocks in the plurality of blocks can include, respectively, a plurality of sub-blocks. The read setup operation can traverse sub-blocks in a block to simultaneously apply the read setup bias to more than one individual sub-block of the selected block. A block status table can be used to identify stale blocks for the read setup operation. Also, the blocks can be traversed as a background operation independent of read commands addressing the blocks. This document via Fig.7 discloses a method of operating a memory device comprising a plurality of word lines, a plurality of ground select lines, a plurality of strings connected to a common source line, and a plurality of string select lines connected to the plurality of strings, wherein the plurality of word lines are connected to each string of the plurality of strings, the method comprising, during a word line setup period of a read operation :applying at a first time point, hereinafter termed t11, a pre-charge voltage to the common source line; applying a pass voltage to a plurality of unselected word lines and a selected word line included in the plurality of word lines such that, at a second time point, hereinafter termed t12, the plurality of unselected word lines and the selected word line reach a first pass voltage; applying an off-voltage to the unselected ground select line at a third time point, hereinafter termed t14; and applying a ground voltage to the common source line at a fourth time point , hereinafter termed t15, wherein t11< t12 < t14 < t15.

### SUMMARY

According to an aspect of the present invention there is provided a method of operating a memory device according to claim 1. Optional features of the method are defined according to the claims dependent on claim 1.

According to an aspect of the present invention there is provided a memory device according to claim 10. Optional features of the memory device are defined according to the claims dependent on claim 10.

### BRIEF DESCRIPTION OF THE DRAWINGS

Embodiments will be more clearly understood from the following detailed description taken in conjunction with the accompanying drawings in which:
FIG. 1 is a diagram illustrating a memory device according to an embodiment;
FIG. 2 is a diagram schematically illustrating the structure of the memory device of FIG. 1, according to an embodiment;
FIG. 3 is diagram illustrating a memory cell array of FIG. 1 as an example;
FIG. 4 is a circuit diagram illustrating an example of a memory block included in a memory cell array, according to an embodiment;
FIG. 5 is a perspective view illustrating a memory block according to an embodiment;
FIG. 6 is a diagram illustrating a memory cell array according to an embodiment;
FIG. 7 is a flowchart illustrating a method of operating a memory device, according to an embodiment;
FIGS. 8A and 8B are timing diagrams illustrating a sensing operation of a memory device, according to an embodiment;
FIGS. 9A to 9C are diagrams illustrating voltages applied to a memory device during a word line setup period, according to an embodiment;
FIG. 10 is a diagram illustrating a memory device according to an embodiment;
FIG. 11 is a diagram illustrating a memory system according to an embodiment;
FIG. 12 is a timing diagram illustrating a sensing operation of a memory device, according to a comparative example;
FIG. 13 is a block diagram illustrating a charge pump system according to an embodiment;
FIG. 14 is a timing diagram illustrating a sensing operation of a memory device, according to an embodiment;
FIG. 15 is a timing diagram illustrating a sensing operation of a memory device, according to an embodiment;
FIG. 16 is a perspective view illustrating a portion of a memory block according to an embodiment;
FIG. 17 is a diagram illustrating threshold voltage distribution in a quadrature level cell (QLC) mode;
FIG. 18 is a timing diagram illustrating a condition for applying a pre-pulse during a second sensing operation, according to an embodiment;
FIG. 19 is a diagram illustrating a memory device according to an embodiment;
FIG. 20 is a diagram illustrating a threshold voltage of a ground select transistor according to an embodiment;
FIG. 21 is a timing diagram illustrating a sensing operation of a memory device, according to an embodiment; and
FIG. 22 is a diagram illustrating a memory device according to an embodiment.

### DETAILED DESCRIPTION OF THE EMBODIMENTS

Hereinafter, various embodiments of the inventive concept will be described with reference to the accompanying drawings.

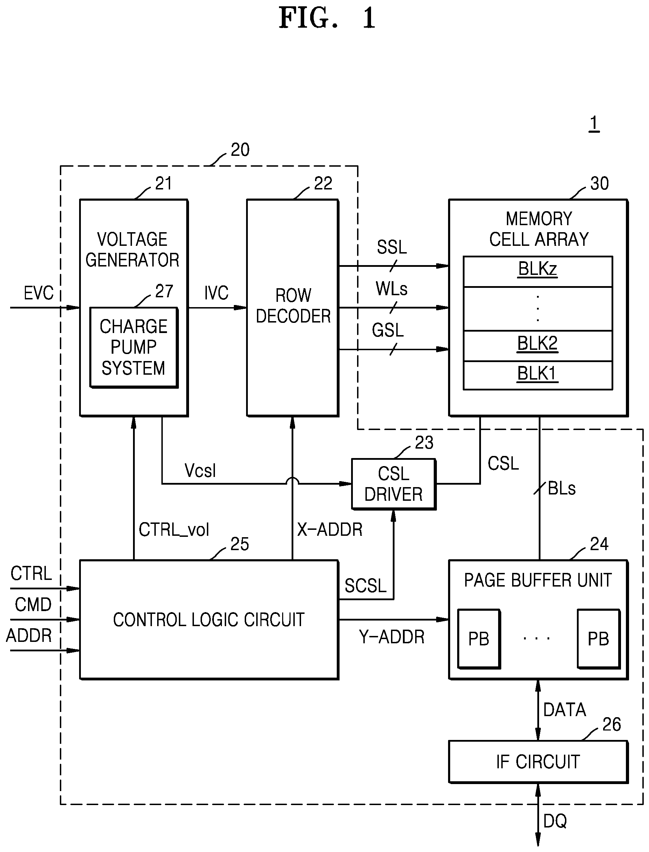

FIG. 1 is a diagram illustrating a memory device 1 according to an embodiment.

Referring to FIG. 1, the memory device 1 may include a voltage generator 21, a row decoder 22, a common source line (CSL) driver 23, a page buffer unit 24, a control logic circuit 25, an interface circuit 26, a charge pump system 27, and a memory cell array 30. The voltage generator 21, the row decoder 22, the CSL driver 23, the page buffer unit 24, the control logic circuit 25, the interface circuit 26, and the charge pump system 27 may be included in a peripheral circuit 20.

The memory device 1 includes a NAND flash memory, or a vertical NAND (VNAND) flash memory. In examples not covered by the claims the memory device 1 may include a NOR flash memory, a resistive random access memory (RRAM), a phase-change memory (PRAM), a magnetoresistive random access memory (MRAM), a ferroelectric random access memory (FRAM), and a spin transfer torque random access memory (STT-RAM). In addition, the memory device 1 may be implemented in a three-dimensional array structure. The inventive concept is applicable to a flash memory device in which a charge storage layer is composed of a conductive floating gate and also to a charge trap flash (CTF) in which a charge storage layer is composed of an insulating layer. Hereinafter, the memory device 1 will be referred to as a VNAND flash memory device.

The memory cell array 30 includes a plurality of memory blocks BLK1 to BLKz, where z is an integer of 2 or more. Each of the memory blocks BLK1 to BLKz is connected to the row decoder 22 via word lines WLs, at least one string select line SSL and at least one (e.g., "a first") ground select line GSL, and to a page buffer unit 24 via bit lines BLs, wherein the word lines WLs may be implemented in the form of stacked plates.

Each of the plurality of memory blocks BLK1 to BLKz is arranged in a first direction and a second direction (different from the first direction) on a substrate, and includes a plurality of strings of a three-dimensional structure arranged in a third direction (perpendicular to a plane formed in the first direction and the second direction). Each of the plurality of strings is composed of at least one string select transistor, a plurality of memory cells, and at least one ground select transistor connected in series between bit lines and a common source line. Each of the plurality of memory cells may store at least one bit. In some embodiments, each of the plurality of strings may include at least one dummy cell between the at least one string select transistor and the plurality of memory cells. In some embodiments, each of the plurality of strings may include at least one dummy cell between the plurality of memory cells and the at least one ground select transistor.

The control logic circuit 25 may generally control various operations within the memory device 1. The control logic circuit 25 may output various control signals in response to a command CMD and/or an address ADDR from the interface circuit 26. For example, the control logic circuit 25 may output a voltage control signal CTRL_vol, a row address X-ADDR, and a column address Y-ADDR.

The row decoder 22 may select one of the plurality of memory blocks BLK1 to BLKz in response to the row address X-ADDR. In addition, the row decoder 22 may be connected to the memory cell array 30 via the word lines WLs, the at least one string select line SSL, and the at least one ground select line GSL. The row decoder 22 may select the word lines WLs, the string select line SSL, and the ground select line GSL using the row address X-ADDR.

The page buffer unit 24 may be connected to the memory cell array 30 via bit lines BLs. The page buffer unit 24 may be implemented to receive the column address Y-ADDR. The page buffer unit 24 may select the bit lines BLs using the column address Y-ADDR.

The page buffer unit 24 may receive data from the interface circuit 26 and store the received data in the memory cell array 30. The page buffer unit 24 may also read data from the memory cell array 30 and provide the read data to the interface circuit 26. The interface circuit 26 may transmit/receive data via a DQ pin.

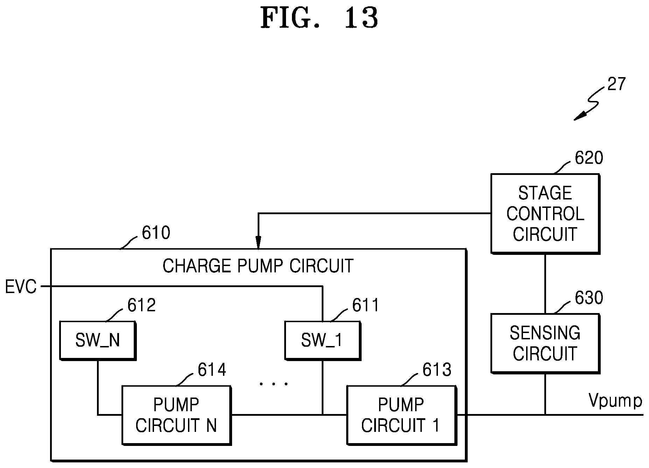

The voltage generator 21 may include the charge pump system 27. The charge pump system 27 is a type of DC-DC converter and may generate an output voltage IVC by stepping up or stepping down an input voltage EVC. The output voltage IVC may be at least one of drive voltages applied to the string select line SSL, the word lines WLs, and the ground select line GSL. The charge pump system 27 may control the level of the output voltage IVC by adjusting the number of pump stages provided with the input voltage EVC. The charge pump system 27 may be described in detail below with reference to FIG. 13.

In an embodiment, the control logic circuit 25 may generate a CSL control signal SCSL for controlling the CSL driver 23.

The CSL driver 23 may receive a CSL voltage Vcsl and provide a voltage corresponding to the CSL voltage Vcs1 to the common source line CSL. In some embodiments, the CSL driver 23 may convert the CSL voltage Vcsl and provide the converted voltage to the common source line CSL. The CSL voltage Vcsl may be generated from the voltage generator 21.

During word line setup for a read operation, a relatively high pass voltage may be applied to the word lines WLs to turn on the memory cells. Accordingly, the charge pump system 27 may generate the output voltage IVC having a higher level than the input voltage EVC. As the number of word lines WLs increases, the capacitance of the word lines WLs may increase, and the word line setup time may increase due to the increased capacitance of the word lines WLs. It is possible to increase the number of activated charge pumps to reduce the word line setup time. However, power consumed by the charge pump system 27 may increase as the number of charge pumps increases.

According to an embodiment, the CSL driver 23 pre-charges a channel of an unselected string by applying the CSL voltage Vcsl to the common source line CSL during word line setup. The word lines WLs are coupled up to the level of the voltage applied for pre-charging the channel of the unselected string. Thus, the voltage of the word lines WLs quickly reaches the target level. By applying the CSL voltage Vcsl to the common source line CSL during word line setup, the word line setup time is reduced while maintaining the number of charge pumps.

According to an embodiment, by applying the CSL voltage Vcsl to the common source line CSL during word line setup, the number of activated pump circuits is reduced, thereby decreasing the power consumption during a read operation. Furthermore, the word line setup time is reduced and thus the read speed is improved.

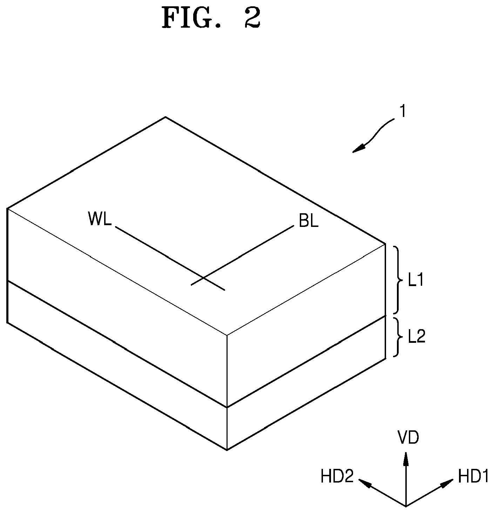

FIG. 2 is a diagram schematically illustrating the structure of the memory device of FIG. 1, according to an embodiment. Although a cell over periphery (COP) structure is illustrated in FIG. 2 as an example of implementation of the memory device 1, embodiments do not need to be limited thereto, and the memory device 1 may be implemented through various structures.

Referring to FIG. 2, the memory device 1 may include a first semiconductor layer L1 and a second semiconductor layer L2, and the first semiconductor layer L1 may be stacked in a vertical direction VD with respect to the second semiconductor layer L2. Specifically, the second semiconductor layer L2 may be positioned below the first semiconductor layer L1 in the vertical direction VD, and thus the second semiconductor layer L2 may be positioned close to the substrate.

In an embodiment, the memory cell array 30 in FIG. 1 may be formed in the first semiconductor layer L1, and the peripheral circuit 20 in FIG. 1 may be formed in the second semiconductor layer L2. Accordingly, the memory device 1 may have a structure, i.e., a COP structure, in which the memory cell array 30 is positioned above the peripheral circuit 20. The COP structure may effectively reduce the area in the horizontal direction and improve the degree of integration of the memory device 1.

In an embodiment, the second semiconductor layer L2 may include a substrate and the peripheral circuit 20 may be formed in the second semiconductor layer L2 by forming transistors and metal patterns for wiring the transistors on the substrate. After the peripheral circuit 20 is formed in the second semiconductor layer L2, the first semiconductor layer L1 including the memory cell array 30 may be formed, and the metal patterns for electrically connecting the word lines WLs and the bit lines BLs of the memory cells array 30 to the peripheral circuit 20 formed in the second semiconducting layer L2 may be formed. For example, the bit lines BLs may extend in a first horizontal direction HD1 and the word lines WLs may extend in a second horizontal direction HD2.

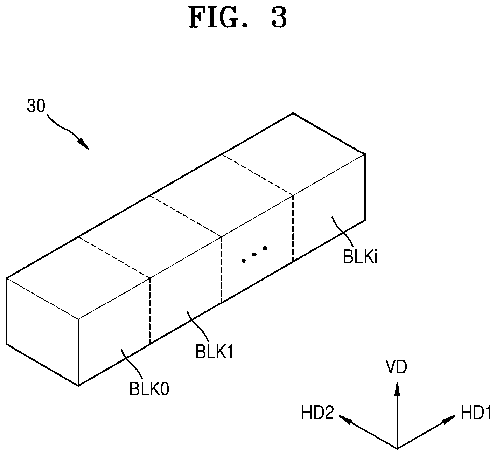

FIG. 3 is diagram illustrating the memory cell array in FIG. 1 as an example.

Referring to FIG. 3, the memory cell array 30 may include a plurality of memory blocks BLK0 to BLKi, where i may be a positive integer. Each of the plurality of memory blocks BLK0 to BLKi may have a three-dimensional structure (or a vertical structure). Specifically, each of the plurality of memory blocks BLK0 to BLKi may include a plurality of NAND strings extending in the vertical direction VD. The plurality of NAND strings may be spaced apart from each other by a specific distance along the first and second horizontal directions HD1 and HD2. The plurality of memory blocks BLK0 to BLKi may be selected by the row decoder (22 in FIG. 1). For example, the row decoder 22 may select a memory block corresponding to a block address from among the plurality of memory blocks BLK0 to BLKi.

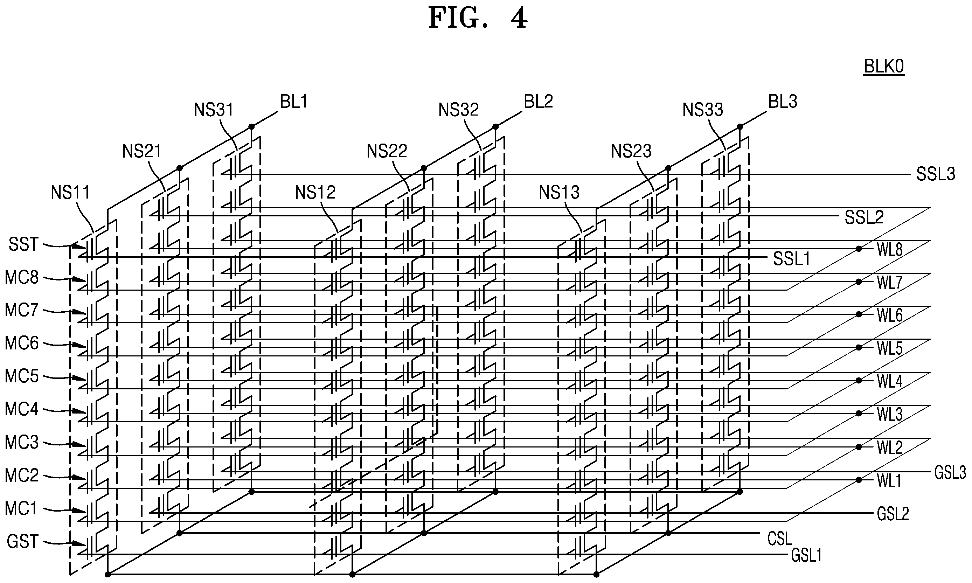

FIG. 4 is a circuit diagram illustrating an example of a memory block included in a memory cell array, according to an embodiment.

Referring to FIG. 4, the memory cell array (e.g., 30 in FIG. 1) may be a memory cell array of a VNAND flash memory and includes a plurality of memory blocks. The memory block BLK0 includes a plurality of NAND cell strings NS11 to NS33, a plurality of word lines WL1 to WL8, a plurality of bit lines BL1 to BL3, a plurality of ground select lines GSL1 to GSL3, a plurality of string select lines SSL1 to SSL3, and a common source line CSL. The number of NAND cell strings, the number of word lines, the number of bit lines, the number of ground select lines, and the number of string select lines may vary depending on an embodiment.

The NAND cell strings NS11, NS21, and NS31 are provided between the first bit line BL1 and the common source line CSL; the NAND cell strings NS12, NS22, and NS32 are provided between the second bit line BL2 and the common source line CSL; and the NAND cell strings NS13, NS23, and NS33 are provided between the third bit line BL3 and the common source line CSL. Each NAND cell string (e.g., NS11) includes a string select transistor SST, a plurality of memory cells MC1 to MC8, and a ground select transistor GST connected in series.

The string select transistor SST is connected to the corresponding string select line SSL1 to SSL3. The plurality of memory cells MC1 to MC8 are respectively connected to the corresponding word lines WL1 to WL8. The ground select transistor GST is connected to the corresponding ground select line GSL1 to GSL3. The string select transistor SST is connected to the corresponding bit line BL1 to BL3, and the ground select transistor GST is connected to the common source line CSL.

The word lines (e.g., WL1) having the same height are commonly connected to each other, the string select lines SSL1 to SSL3 are separated from each other, and the ground select lines GSL1 to GSL3 are also separated from each other. For example, when programming memory cells connected to the first word line WL1 and included in the cell strings NS11, NS12, and NS13, the first word line WL1 and the first string select line SSL1 are selected. At least two of the ground select lines GSL1 to GSL3 may be commonly connected to each other.

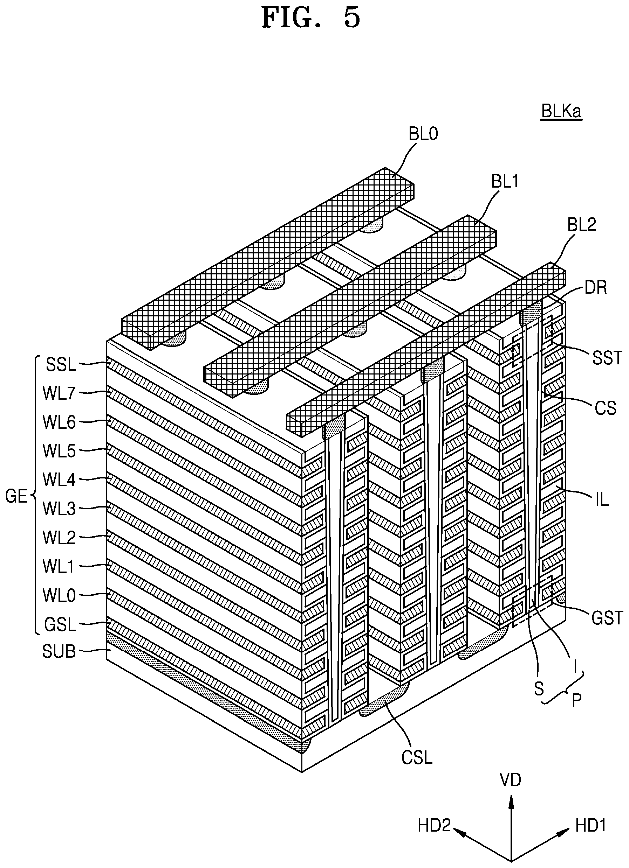

FIG. 5 is a perspective view illustrating a memory block according to an embodiment.

Referring to FIG. 5, the memory block BLKa is formed in a direction perpendicular to a substrate SUB. The substrate SUB has a first conductivity type (e.g. p-type) and is provided with common source lines CSL extending in the second horizontal direction HD2 on the substrate SUB and doped with impurities of a second conductivity type (e.g., n-type). On a region of the substrate SUB between two adjacent common source lines CSL, a plurality of insulating layers IL extending in the second horizontal direction HD2 are sequentially provided in the vertical direction VD, and the plurality of insulating layers IL are spaced apart by a specific distance in the vertical direction VD. For example, the plurality of insulating layers IL may include an insulating material such as silicon oxide.

On a region of the substrate SUB between two adjacent common source lines CSL, a plurality of pillars P are provided, which are sequentially arranged in the first horizontal direction HD1 and pass through the plurality of insulating layers IL in the vertical direction VD. For example, the plurality of pillars P may pass through the plurality of insulating layers IL and contact the substrate SUB. Specifically, a surface layer S of each pillar P may include a silicon material of a first type and may function as a channel region, while an inner layer I of each pillar P may include an insulating material such as silicon oxide or an air gap.

In a region between two adjacent common source lines CSL, a charge storage layer CS is provided on the exposed surfaces of the insulating layers IL, the pillars P, and the substrate SUB. The charge storage layer CS may include a gate insulating layer (also referred to as a "tunneling insulating layer"), a charge trapping layer and a blocking insulating layer. For example, the charge storage layer CS may have an oxide-nitride-oxide (ONO) structure. In addition, in the region between two adjacent common source lines CSL, a gate electrode GE such as select lines GSL and SSL and word lines WL0 to WL7 is provided on the exposed surface of the charge storage layer CS.

Drains or drain contacts DR are respectively provided on the plurality of pillars P. For example, the drains or drain contacts DR may include a silicon material doped with impurities having the second conductivity type. The bit lines BL1 to BL3 extending in the first horizontal direction HD1 and spaced apart from each other by a specific distance in the second horizontal direction HD2 are provided on the drains DR.

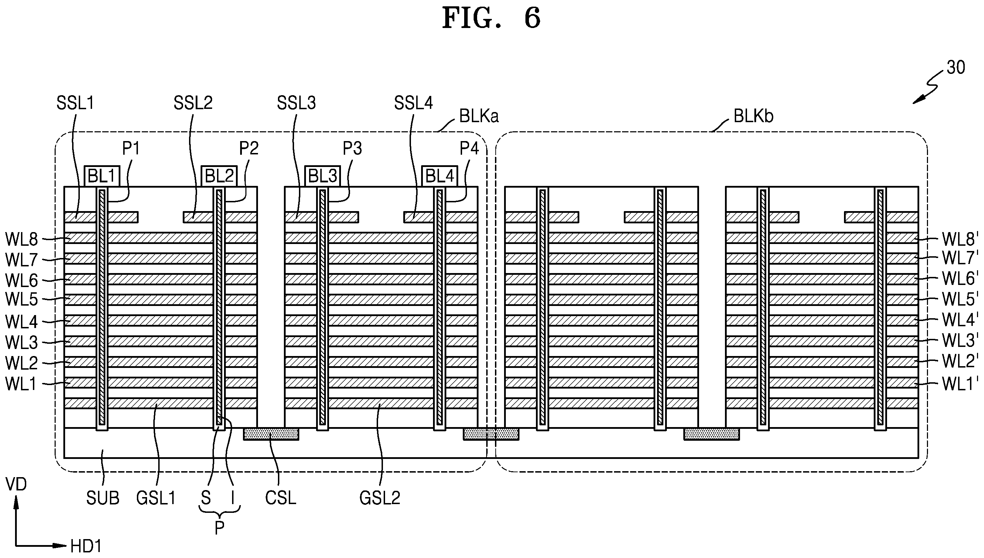

FIG. 6 is a diagram illustrating a memory cell array according to an embodiment.

Referring to FIG. 6, the memory cell array 30 may include memory blocks BLKa and BLKb. The memory blocks BLKa and BLKb may be physically separated by a word line cut. Thus, the word lines WL1 to WL8 connected to the memory block BLKa and the word lines WL1'-WL8' connected to the memory block BLKb may be controlled independently. The above description with reference to FIG. 5 may be omitted as the description of the memory block BLKa may also be applied to the memory block BLKb.

The memory block BLKa may include pillars P1 to P4, which may be connected to bit lines BL1 to BL4, respectively. Each of the pillars P1 to P4 may include transistors constituting one string.

The pillars P1 to P4 may be electrically connected to the substrate SUB by the ground select lines GSL1 and GSL2. The ground select line GSL1 may be physically separated from the ground select line GSL2. Thus, the pillars P1 and P2 and the pillars P3 and P4 may be independently electrically connected to the substrate SUB.

The pillars P1 to P4 may be electrically connected to the bit lines BL1 to BL4 by string select lines SSL1 and SSL2. The string select lines SSL1 and SSL2 may be physically separated.

Although not shown, each of the string select lines SSL1 to SSL4 may be composed of a plurality of layers which are independently controlled.

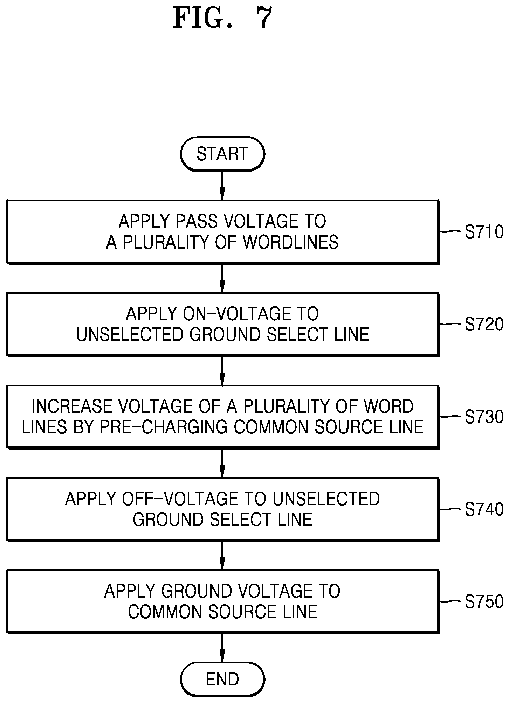

FIG. 7 is a flowchart illustrating a method of operating a memory device, according to an embodiment. FIG. 7 may be described below with reference to FIGS. 1 and 6. The method of operating the memory device in FIG. 7 may be performed during a word line setup period of a sensing operation. The sensing operation may be a read operation or a verification operation.

Referring to FIG. 7, the memory device 1 applies a pass voltage to the plurality of word lines WL1 to WL8 for word line setup (S710). The pass voltage may have a voltage level at which the memory cells connected to the plurality of word lines WL1 to WL8 are turned on.

The memory device 1 applies an on-voltage to an unselected ground select line GSL2 (S720). The on-voltage is a voltage that turns on the transistor, and an off-voltage is a voltage that turns off the transistor. The unselected ground select line refers to a ground select line that is not electrically connected to a selected string. A selected ground select line refers to a ground select line that is electrically connected to the selected string. For example, referring to FIG. 6, when the pillar P1 includes a selected memory cell, the ground select line GSL1 may be the selected ground select line, and the ground select line GSL2 may be the unselected ground select line. The selected memory cell refers to a memory cell that is subject to a sensing operation. By applying the on-voltage to the unselected ground select line GSL2, the pillars P3 and P4 may be connected to the substrate SUB. Furthermore, the memory device 1 applies the off-voltage to the selected ground select line GSL1.

The memory device 1 increases the voltage of the plurality of word lines by pre-charging the common source line CSL (S730). Specifically, the CSL voltage Vcsl applied to the common source line CSL is transferred to the channels of the unselected strings formed by the pillars P3 and P4. The voltage level of the plurality of word lines WL1 to WL8 is increased by being coupled up by the voltage level of the channels. Voltage slopes of the plurality of word lines WL1 to WL8 increase as a result of the application of the CSL voltage Vcsl to the common source line CSL.

The memory device 1 applies the off-voltage to the unselected ground select line GSL2 (S740). Accordingly, the unselected strings formed by the pillars P3 and P4 may be electrically disconnected from the substrate SUB.

The memory device 1 applies a ground voltage GND to the common source line CSL (S750).

According to an embodiment, by pre-charging the channels of the unselected strings based on the CSL voltage Vcsl, the voltage of the word lines is coupled up and the word line setup time is shortened.

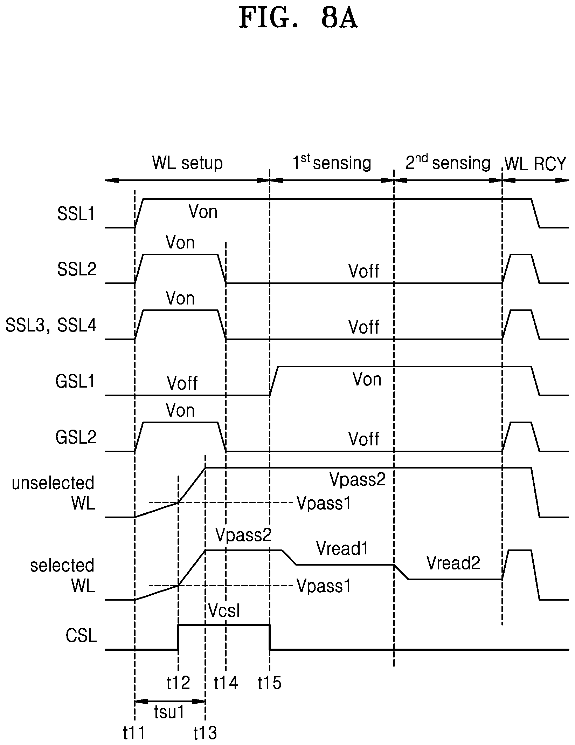

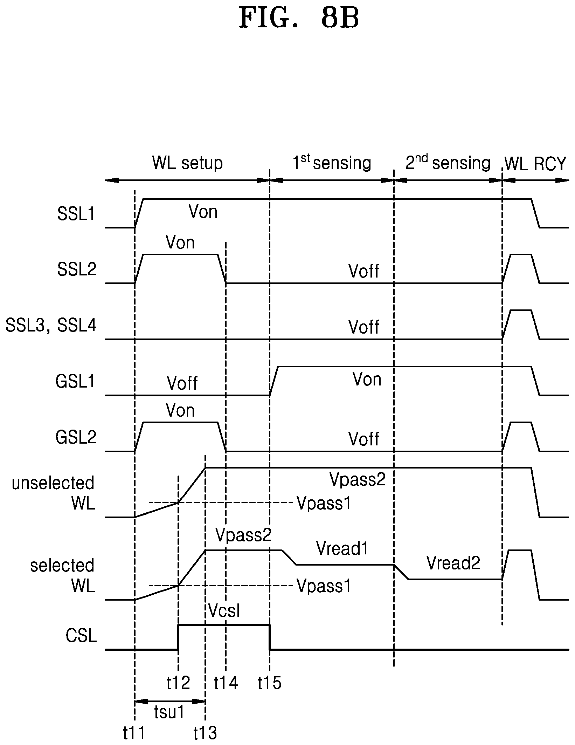

FIGS. 8A and 8B are timing diagrams illustrating a sensing operation of a memory device, according to an embodiment. FIGS. 8A and 8B may be described below with reference to FIGS. 1 and 6.

Referring to FIG. 8A, the sensing operation includes a word line setup period, a first sensing period, a second sensing period, and a word line recovery period. Although the first sensing period and the second sensing period are illustrated, the number of sensing periods is not limited thereto. It may be assumed that the selected memory cell is included in the string formed by the pillar P1. For example, the string formed by the pillar P1 may be a selected string, and the strings formed by the pillars P2 to P4 may be unselected strings. The string select line SSL1 may be a selected string select line, and the string select lines SSL2 to SSL4 may be unselected string select lines.

A first pass voltage Vpass1 is applied to the unselected word lines and the selected word line from the first time point t11. Thus, the voltage levels of the unselected word lines and the selected word line increase toward the level of the first pass voltage Vpass1. The first pass voltage Vpass1 may be, for example, 5V.

The on-voltage Von may be applied to the string select lines SSL1 to SSL4 at the first time point t11. The memory cells connected to the string select lines SSL1 to SSL4 may be turned on by applying the on-voltage Von, and the channel level of the strings may be initialized by connecting the channels of the strings to the bit lines BL1 to BL4 having the ground GND level.

At the first time point t11, the off-voltage Voff may be applied to the ground select line GSL1, and the on-voltage Von is supplied to ground select line GSL2. Since the selected memory cell is included in the string of the pillar P1, the ground select line GSL1 may be the selected ground select line and the ground select line GSL2 is the unselected ground select line.

At the second time point t12, the common source line CSL is pre-charged to the CSL voltage Vcsl level. As the CSL voltage Vcsl is applied, the channel of the unselected string is pre-charged. Voltages of the unselected word line and the selected word line increase due to coupling between the channel of the unselected string and the word lines.

The voltage level of the unselected word line and the selected word line at the third time point t13 reaches the level of a second pass voltage Vpass2. The time for the voltage level of the unselected word line and the selected word line to reach the second pass voltage Vpass2, i.e., the time period from the first time point t11 to the third time point t13, may be referred to as a first setup time tsu1. The level of the second pass voltage Vpass2 is higher than that of the first pass voltage Vpass1. For example, the second pass voltage Vpass2 may be 6V.

The off-voltage Voff is applied to the unselected string select lines SSL2 to SSL4 and the unselected ground select line GSL2 at the fourth time point t14.

The ground voltage is applied to the common source line CSL at the fifth time point t15. Furthermore, the on-voltage Von may be applied to the selected ground select line GSL1 at the fifth time point t15. Thus, the selected string formed by the pillar P1 may be electrically connected to the first bit line BL1.

In the first and second sensing periods, the voltage applied to the unselected word line may be maintained at the second pass voltage Vpass2. In the first sensing period, the voltage applied to the selected word line may be adjusted to a first read voltage Vread1. During the first sensing period, the page buffer unit 24 may sense at least one bit stored in the selected memory cell. In the second sensing period, the voltage applied to the selected word line may be adjusted to a second read voltage Vread2. During the second sensing period, the page buffer unit 24 may sense another bit that is not sensed in the first sensing period from the selected memory cell.

During the word line recovery period, a recovery operation may be performed on the string select lines SSL1 to SSL4, the ground select lines GSL1 and GSL2, the unselected word lines, and the selected word line.

Referring to FIG. 8B, unlike FIG. 8A, the off-voltage Voff may be applied to the string select lines SSL3 and SSL4 from the first time point t11 to the fourth time point t14 of the word line setup period.

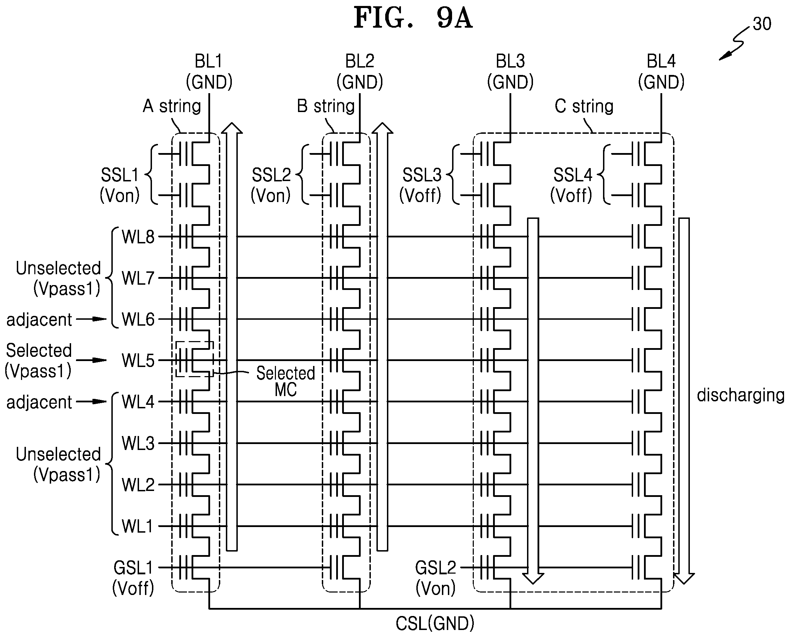

FIGS. 9A to 9C are diagrams illustrating voltages applied to a memory device during a word line setup period, according to an embodiment.

FIG. 9A is a diagram illustrating the memory cell array 30 between the first time point t11 and the second time point t12 in FIG. 8B.

Referring to FIG. 9A, among the word lines WL1 to WL8, the word line WL5 connected to the selected memory cell MC may be referred to as a selected word line, and the other word lines WL1 toWL4 and WL6 to WL8 may be referred to as unselected word lines. Further, the word lines WL4 and WL6 adjacent to the selected word line WL5 may be referred to as adjacent word lines. The first pass voltage Vpass1 is applied to the word lines WL1 to WL8.

The memory cell string included in the memory cell array 30 may be divided into a string A, a string B, and a string C. The string A is a selected cell string and may include a selected memory cell MC. The string B and the string C are unselected cell strings and may not include the selected memory cell MC. Referring to FIG. 9A, the string A may be connected to the first bit line BL1 and the common source line CSL during the sensing periods. The string B may be connected to the common source line CSL, not to the second bit line BL2, during the sensing periods. The string A and the string B may share the ground select line GSL1. The string C may be connected neither to the third and fourth bit lines BL3 and BL4 nor to the common source line CSL during the sensing periods.

The time period between the first time point t11 and the second time point t12 may be referred to as a channel initialization period. In the channel initialization period, the channels of the string A, the string B, and the string C may be initialized to the ground level. The channels may be initialized by discharging current in the direction of the bit lines through the channels of the string A and the string B, and the channels may be initialized by discharging current in the direction of the common source line CSL through the channel of the String C. The bit lines BL1 to BL4 and the common source line CSL may have a ground level.

Specifically, by applying the on-voltage Von to the string select lines SSL1 and SSL2, applying the off-voltage Voff to the ground select line GSL1, and applying the pass voltage Vpass to the word lines WL1 to WL8, the channels of the string A and the string B may be initialized in the direction of the bit lines BL1 and BL2.

By applying the off-voltage Voff to the string select lines SSL3 and SSL4, applying the on-voltage Von to the ground select line GSL2, and applying the pass voltage Vpass to the word lines WL1 to WL8, the channel of the string C may be initialized in the direction of the common source line CSL.

The on-voltage Von may be applied to the string select lines SSL3 and SSL4 between the first time point t11 and the second time point t12 as shown in FIG. 8A.

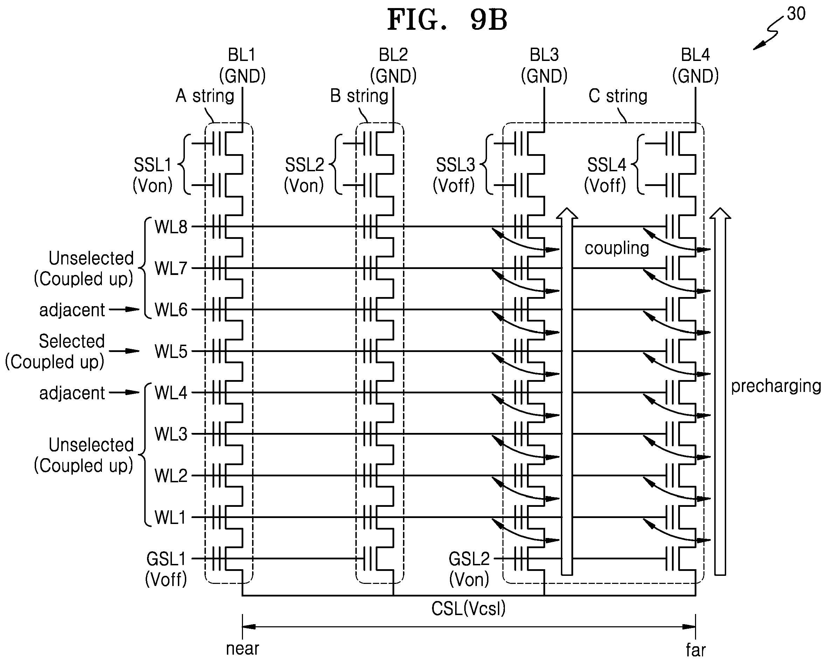

FIG. 9B is a diagram illustrating the memory cell array 30 between the second time point t12 and the third time point t13 in FIG. 8B.

The CSL voltage Vcsl is applied to the common source line CSL. The channel of the string C is pre-charged with current in the direction of the common source line CSL. The word lines WL1 to WL8 are coupled with the pre-charged channel of the string C. For example, the voltage level of the word lines WL1 to WL8 is increased by being coupled up by the voltage level of the channel of the string C.

The word lines WL1 to WL8 may be driven from the near direction to the far direction. For example, the voltage applied in the near direction may be transferred in the far direction. According to an embodiment, since the voltage level of the word lines WL1 to WL8 is coupled up by pre-charging the channel of the string C in the direction of the common source line CSL, the setup time deviation between the far direction and the near direction is reduced.

Furthermore, a shift in threshold voltage distribution, i.e., read disturbance, may occur due to a voltage difference between the channel of the string and the word lines WL1 to WL8. According to an embodiment, the voltage difference between the channel of the string C and the word lines WL1 to WL8 may be reduced compared to a case where the voltage level of the common source line CSL is the ground level. Thus, the read disturbance may be prevented.

The on-voltage Von may be applied to the string select lines SSL3 and SSL4 between the first time point t11 and the third time point t13 as shown in FIG. 8A.

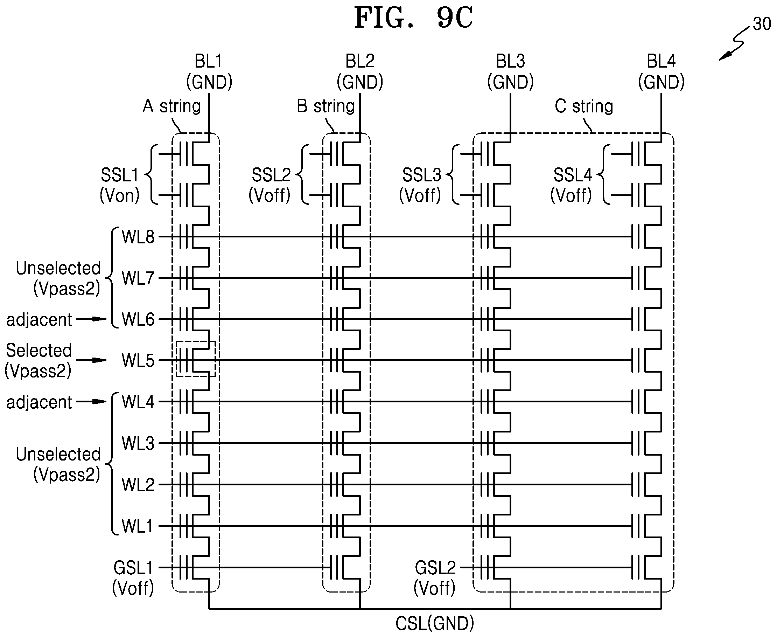

FIG. 9C is a diagram illustrating the memory cell array 30 at the fifth time point t15 in FIGS. 8A and 8B.

The common source line CSL is recovered to the ground level, and the on-voltage Von may be applied to the string select line SSL1, and the off-voltage Voff may be applied to the string select lines SSL2, SSL3, and SSL4. The voltage of the word lines WL1 to WL8 is the second pass voltage Vpass2. The memory cells connected to the word lines WL1 to WL8 are turned on by applying the second pass voltage Vpass2 to the word lines WL1 to WL8.

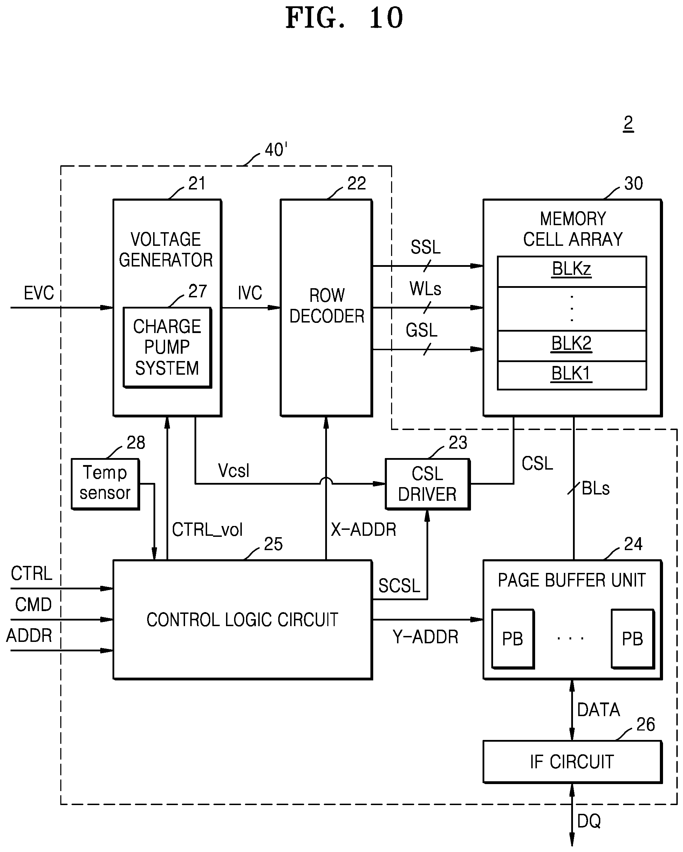

FIG. 10 is a diagram illustrating a memory device according to an embodiment.

Details of the embodiment illustrated in FIG. 10 that are common to the description above with reference to FIG. 1 are omitted for brevity.

Referring to FIG. 10, a memory device 2 may include a temperature sensor 28. The control logic circuit 25 may obtain information about the temperature of the memory device 2 from the temperature sensor 28. The control logic circuit 25 may control the CSL driver 23 to adjust the CSL voltage Vcsl according to the temperature of the memory device 2. For example, the CSL driver 23 may be controlled so that, as the temperature of the memory device 2 increases, the higher CSL voltage Vcsl is applied to the common source line CSL.

Specifically, since hot carrier injection (HCI) actively occurs when the temperature of the memory device 2 increases, the amount of shift in the threshold voltage distribution may increase due to read disturbance. According to an embodiment, by increasing the level of the CSL voltage Vcsl as the temperature of the memory device 2 increases, the amount of shift in the threshold voltage distribution may be reduced due to read disturbance.

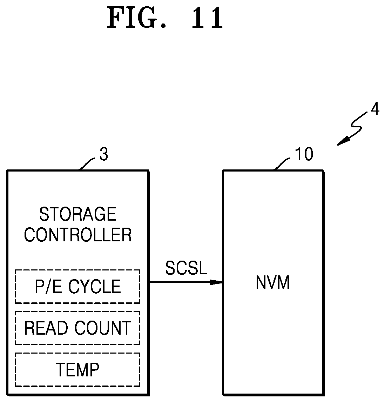

FIG. 11 is a diagram illustrating a memory system according to an embodiment.

Referring to FIG. 11, the memory system 4 may include a non-volatile memory 10 and a storage controller 3.

The non-volatile memory 10 may correspond to the memory device 1 in FIG. 1 or the memory device 2 in FIG. 10. The storage controller 3 may store information about program/erase (P/E) cycles, a read count, or a temperature of the memory system 4. Although not shown, the information about PE cycles, read count or temperature may be stored in memory located inside or outside the storage controller 3. The PE cycles may indicate the number of erases of the memory block (e.g., BLK1 in FIG. 1). The read count may indicate the number of reads for at least one memory cell connected to one word line. The higher the PE cycles or the read count, the more easily the shift in threshold voltage distribution occurs due to the occurrence of cracks in the insulating layer that stores charge. Therefore, the storage controller 3 according to an embodiment may improve the reliability of the read operation by generating the CSL control signal SCSL based on the information about the PE cycles, the read count or the temperature of the memory system 4.

For example, the storage controller 3 may generate the CSL control signal SCSL so that, as the PE cycle increases, a higher voltage is applied to the common source line CSL in the word line setup period. Alternatively, the storage controller 3 may generate the CSL control signal SCSL so that, as the read count increases, a higher voltage is applied to the common source line CSL in the word line setup period. Alternatively, the storage controller 3 may generate the CSL control signal SCSL so that, as the temperature of the memory system 4 increases, a higher voltage is applied to the common source line CSL in the word line setup period.

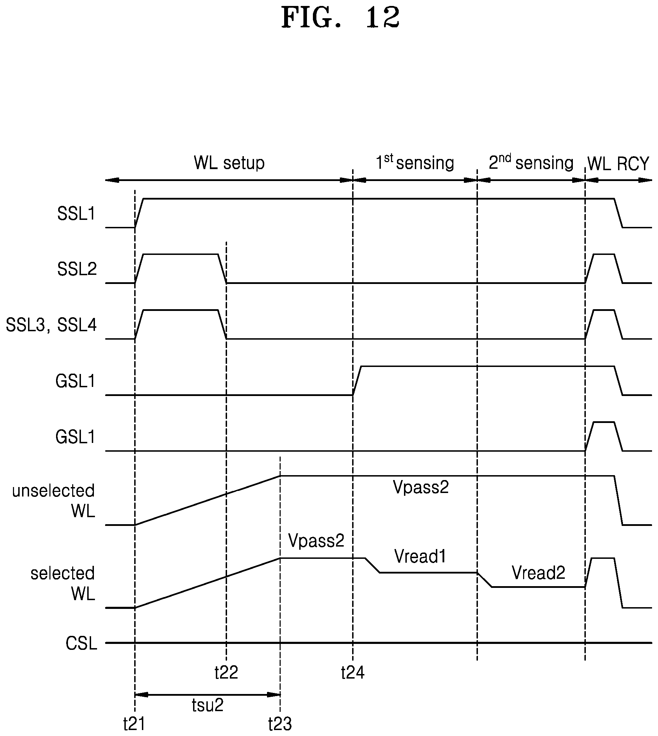

FIG. 12 is a timing chart illustrating a sensing operation of a memory device, according to a comparative example.

Details of the timing chart illustrated in FIG. 12 that are common to the description above with reference to FIG. 8A or FIG. 8B are omitted for brevity.

A period from the first time point t21 to the fourth time point t24 may be the word line setup period. During the word line setup period, the second pass voltage Vpass2 may be applied to the selected and unselected word lines.

The off-voltage may be applied to the string select lines SSL2, SSL3, and SSL4 at the second time point t22.

The voltage of the selected and unselected word lines at the third time point t23 may reach the second pass voltage Vpass2. The time at which the voltage level of the unselected and the selected word lines reaches the second pass voltage Vpass2, i.e., the time period from the first time point t21 to the third time point t23, may be referred to as a second setup time tsu2. According to the embodiment in FIG. 8A and 8B, since the voltage of the word lines is coupled up by the CSL voltage Vcsl applied to the common source line CSL, the first setup time tsu1 in FIG. 8A and 8B may be shorter than the second setup time tsu2.

At the fourth time point t24, the on-voltage Von may be applied to the ground select line GSL1, and the first sensing period may begin.

FIG. 13 is a block diagram illustrating a charge pump system 27 according to an embodiment.

The charge pump system 27 may include a charge pump circuit 610, a stage control circuit 620, and a sensing circuit 630. The charge pump system 27 may generate an output voltage Vpump by stepping up or stepping down the input voltage EVC. The output voltage Vpump may be the output voltage IVC in FIG. 1. The output voltage Vpump may be the CSL voltage Vcsl in FIG. 1.

The charge pump circuit 610 may include first to N^{th} pump circuits 613 and 614 and first to N^{th} switches 611 and 612. The first to N^{th} pump circuits 613 and 614 may be activated by turning on the first to N^{th} switches 611 and 612. As the number of activated pump circuits among the first to N^{th} pump circuits 613 and 614 is adjusted, the level or slope of the output voltage Vpump may be controlled.

The sensing circuit 630 may compare the voltage level of the output voltage Vpump with a reference level, and control the stage control circuit 620 according to the comparison result. The stage control circuit 620 may control the number of activated pump circuits among the first to N^{th} pump circuits 613 and 614, i.e., the number of stages. The stage control circuit 620 may control the activation timings of the first to N^{th} pump circuits 613 and 614.

According to an embodiment, the CSL driver 23 may pre-charge the common source line CSL based on the CSL voltage Vcsl, and the voltage of the word lines may be increased by being coupled up by the pre-charged common source line CSL. The charge pump system 27 may reduce the power consumed to generate the drive voltage by decreasing the number of stages for generating the voltage applied to the word lines.

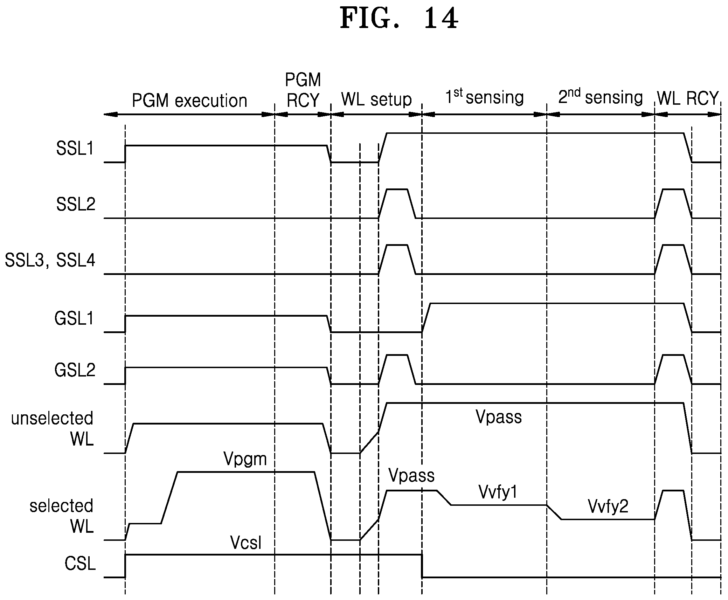

FIG. 14 is a timing diagram illustrating a sensing operation of a memory device, according to an embodiment. Details of the timing chart illustrated in FIG. 14 that are common to the description above with reference to FIG. 8A, 8B or FIG. 12 are omitted for brevity.

Referring to FIG. 14, program execution and program recovery may be performed before the word line setup period of the sensing operation. For example, the sensing operation in FIG. 14 may be a verification operation.

In a program execution period, data may be programmed into the memory cells connected to the selected word line by applying a program voltage Vpgm to the selected word line.

In a program recovery period, the voltage levels of the string select lines SSL1 to SSL4, the ground select lines GSL1 and GSL2, the selected word line and the unselected word line may be recovered to the ground level. On the other hand, the voltage of the common source line CSL may be maintained at the CSL voltage Vcsl without being recovered in the program recovery period.

According to an embodiment, it is possible to save time and power used to recover the common source line CSL, without recovering the voltage, by maintaining the voltage of the common source line CSL pre-charged during the program operation until the word lines of the verification operation are set up.

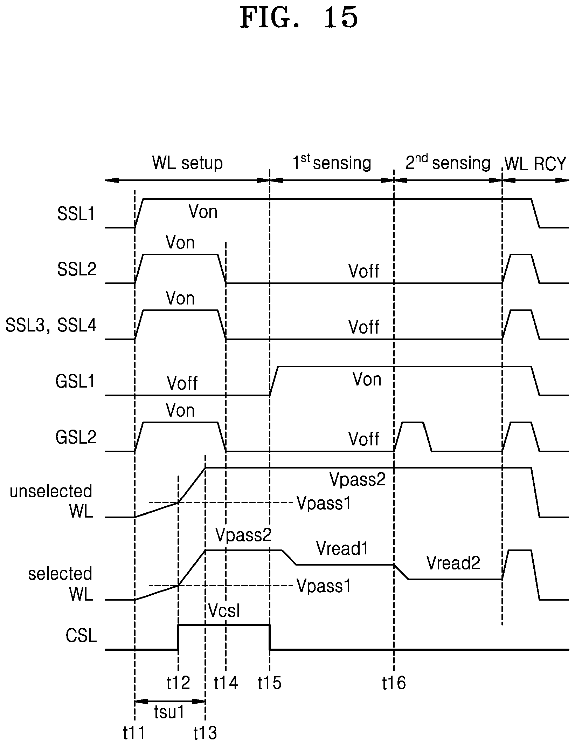

FIG. 15 is a timing diagram illustrating a sensing operation of a memory device, according to an embodiment. Details of the timing chart illustrated in FIG. 14 that are common to the description above with reference to FIG. 8A or 8B are omitted for brevity.

Referring to FIG. 15, after the first sensing period ends, a pre-pulse may be applied to the ground select line GSL2 at a sixth time point t16. The channel of the string C may be initialized by applying the pre-pulse.

The level of the second read voltage Vread2 applied to the selected word line in the second sensing period may be a negative level. Thus, when the channel of the string C is charged with voltage, the HCI may occur due to the voltage level difference between the selected word line and the channel of the string C. The threshold voltage distribution may be shifted due to the HCI.

According to an embodiment, the HCI may be prevented by initializing the channel of the string C before the second sensing operation is performed.

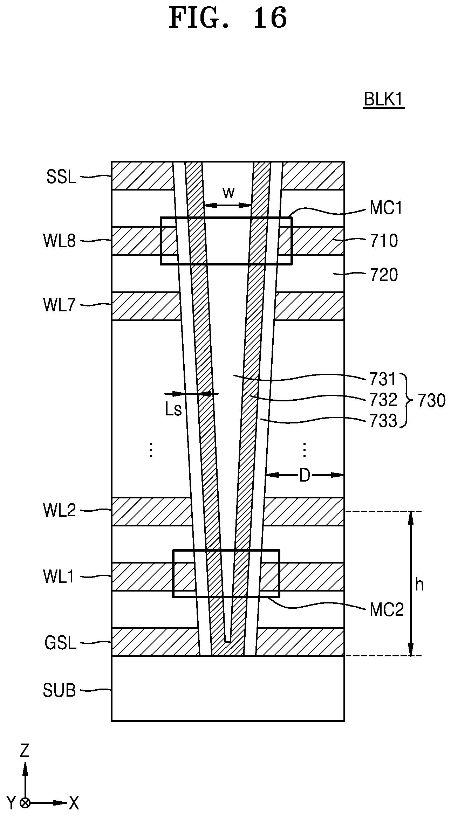

As described in FIG. 16, the pre-pulse may be selectively applied to the ground select line GSL2 based on characteristics of the selected word line. For example, if an amount of shift of the threshold voltage distribution is relatively great according to the characteristics of the selected word line, the channel of the string C may be initialized by applying the pre-pulse. If the amount of shift of the threshold voltage distribution is relatively small according to the characteristics of the selected word line, the channel of the string C may not be initialized. The characteristics of the selected word line may include at least one of a stacking position of the selected word line, a width of the channel hole connected to the selected word line, a distance between a channel and an end of the selected word line and a thickness of an insulating layer between the selected word line and the channel and a voltage level applied to the selected word line.

FIG. 16 is a perspective view illustrating a portion of a memory block according to an embodiment.

Referring to FIG. 16, as an example, the memory block BLK1 of the three-dimensional structure may include gate electrodes GE 710, and insulating layers IL 720 arranged alternately in the vertical direction. In addition, a channel structure 730 may include a channel 732, a dielectric film structure 733 surrounding an outer wall of the channel 732, and a channel fill film pattern 731 positioned within the channel 732. The structure as described above is only an example, and the memory block BLK1 of the three-dimensional structure according to some embodiments may have various other structures in which at least two etching processes are performed.

As shown in FIG. 16, the width w of the channel structure 730 may become narrower in a vertically downward direction. Since charge storage becomes unstable as the width w becomes narrower, the degree of shift in the threshold voltage distribution of the second memory cell MC2 having a relatively narrow channel, compared to the first memory cell MC1 having a relatively wide channel, may be relatively large due to retention or disturbance. An inner diameter of the channel 732, that is, the width w of the fill film pattern 731 may be referred to as a width of channel hole. An embodiment is not limited thereto, an outer diameter of the channel 732 may be referred to as the width of channel hole.

The thickness Ls of a relatively low part of the dielectric film structure 733 may be narrower than the thickness Ls of a relatively high part of the dielectric film structure 733. As the thickness Ls of the dielectric film structure 733 becomes narrower, the charge storage may become more unstable. Accordingly, as the thickness Ls of the dielectric film structure 733 included in the memory cell becomes narrower, the degree of shift in the threshold voltage distribution may be relatively large. The thickness Ls of the dielectric film structure 733 may be referred to as a thickness of an insulating layer between a word line and a channel.

As shown in FIG. 16, as the height h of the word lines becomes lower, the width w of the channel structure 730 may become narrower. The height h of the word lines may be referred to as a stacking position of the word lines. For example, compared to the first memory cell MC1 formed at a high position, the degree of shift in the threshold voltage distribution of the second memory cell MC2 formed at a low position may be relatively large due to disturbance.

As shown in FIG. 16, the length D of the word lines may refer to a distance between the word line cut and the sidewall of the channel structure 730. The length D of the word lines may be referred to a distance between the channel and an end of the word line. Since the channel structure 730 becomes narrower in a vertically downward direction, the length D of the word lines may become longer in the vertical downward direction. For example, the degree of shift in the threshold voltage distribution of the second memory cell MC2 connected to the relatively long word line, compared to the first memory cell MC1 connected to the relatively short word line, may be relatively large due to disturbance.

According to an embodiment, when sensing data from a memory cell whose threshold voltage distribution shifts relatively easily, as described above with reference to FIGS. 1 to 15, the disturbance may be prevented by applying the CSL voltage Vcsl to the common source line CSL during word line setup.

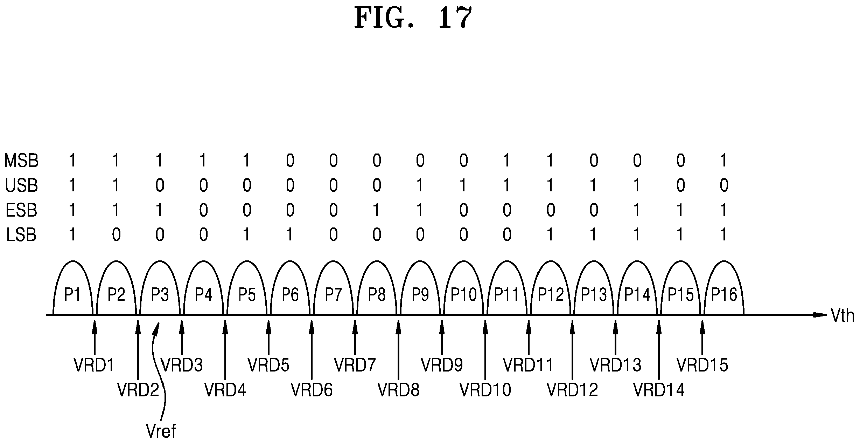

FIG. 17 is a diagram illustrating threshold voltage distribution in a quadrature level cell (QLC) mode.

Referring to FIG. 17, in the QLC mode, the threshold voltages of the memory cells may form first to sixteenth program states P1 to P16. Four bits may be stored in one memory cell. The four bits may be referred to as MSB, USB, ESB, and LSB, respectively. The MSB may refer to the most significant bit, the USB may refer to the next most significant bit, the LSB may refer to the least significant bit, and the ESB may refer to the next least significant bit. As shown in FIG. 17, the plurality of program states may correspond to four different bit values. Although the QLC mode is described in FIG. 17, an embodiment is not limited thereto, and the description of FIG. 17 may be applied to a mode in which a plurality of bits are stored in one memory cell, such as an MLC mode, a TLC mode, and the like.

The bit values corresponding to the first to sixteenth program states P1 to P16 may be distinguished based on first to fifteenth read voltages VRD1 to VRD15. For example, referring to FIG. 17, the LSB values may be distinguished based on the first, fourth, sixth, and eleventh read voltages VRD1, VRD4, VRD6, and VRD11; the ESB values may be distinguished based on the third, seventh, ninth, and thirteen read voltages VRD3, VRD7, VRD9, and VRD13; the USB values may be distinguished based on the second, eighth, and fourteenth read voltages VRD2, VRD8, and VRD14; and the MSB values may be distinguished based on the fifth, tenth, twelfth, and fifteenth read voltages, VRD5, VRD10, VRD12, and VRD15. In FIG. 17, the levels of the first to sixteenth read voltages VRD1 to VRD16 may be different from each other. For example, the read voltage level may need to be changed 15 times to read the 4 bit values corresponding to the first to sixteenth program states P1 to P16.

Referring to FIG. 17, the voltage level of the reference voltage Vref may be greater than the voltage level of the second read voltage VRD2 and lower than the voltage value of the third read voltage VRD3. However, an embodiment may not be limited thereto.

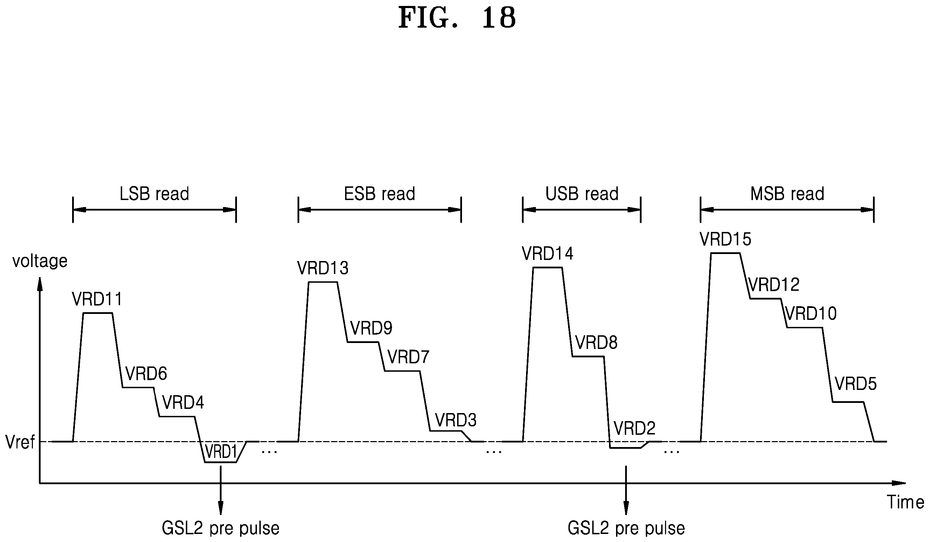

FIG. 18 is a timing diagram illustrating a condition for applying a pre-pulse during a second sensing operation, according to an embodiment.

Referring to FIG. 18, according to an embodiment, in an LSB read period, an ESB read period, a USB read period, or an MSB read period, the level of the read voltage may be changed multiple times. The LSB read period, the ESB read period, the USB read period or the MSB read period in FIG. 18 may include the first sensing period or second sensing period in FIG. 15.

Referring to FIG. 18, a pre-pulse may be applied to the ground select line GSL2 when the first read voltage VRD1 and the second read voltage VRD2 lower than the reference voltage Vref are applied to the selected word line.

For example, the channel of the string C may be initialized by applying a pre-pulse to the ground select line GSL2 to prevent disturbance due to a voltage difference between the read voltage lower than the reference voltage Vref and the voltage remaining in the channel of the string C.

By initializing the channel of the C string, the shift in threshold voltage distribution due to read disturbance may be prevented.

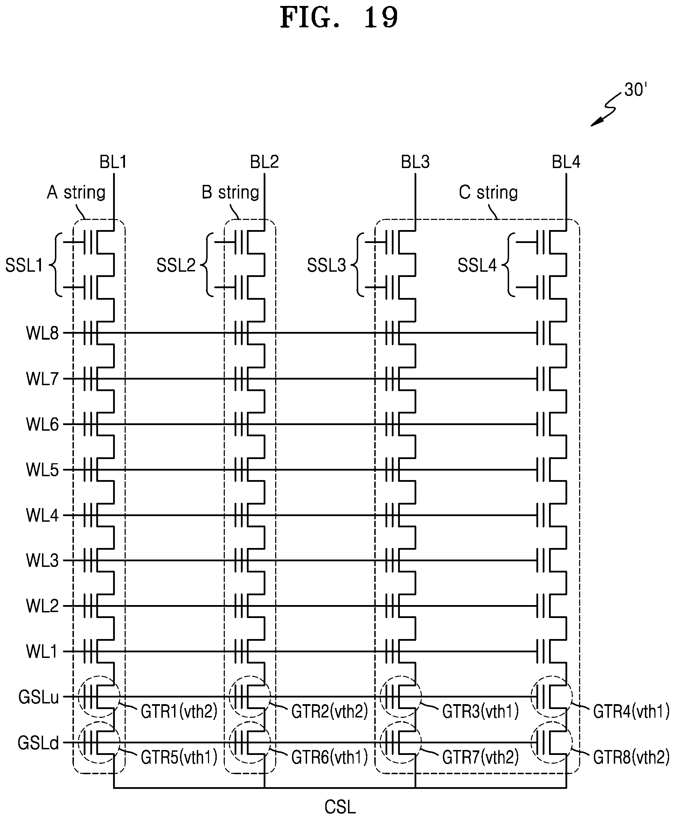

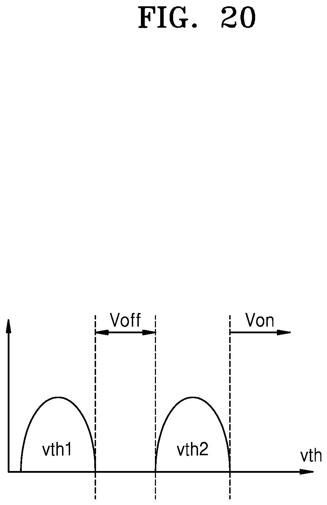

FIG. 19 is a diagram illustrating a memory device according to an embodiment. FIG. 20 is a diagram illustrating a threshold voltage of a ground select transistor according to an embodiment.

Referring to FIG. 19, a memory cell array 30', unlike the memory cell array 30 in FIG. 9A, may include an upper ground select line GSLu and a lower ground select line GSLd that are commonly connected to the strings A to C.

Each of the ground select transistors GTR1 to GTR8 connected to the upper ground select line GSLu and the lower ground select lines GSLd may be programmed to have a first threshold voltage vth1 or a second threshold voltage Vth2.

For example, the ground select transistors GTR1, GTR2, GTR7, and GTR8 may be programmed to have the second threshold voltage vth2, and the ground select transistors GTR3, GTR4, GTR5, and GTR6 may be programmed to have the first threshold voltage Vth1.

Referring to FIG. 20, the first threshold voltage vth1 may be lower than the second threshold voltage Vth2.

Each of the ground select transistors GTR1, GTR2, GTR7, and GTR8 may be turned off when the off-voltage Voff between the first threshold voltage vth1 and the second threshold voltage Vth2 is applied, and may be turned on when the on-voltage Von higher than the second threshold voltage Vth2 is applied.

Each of the ground select transistors GTR3, GTR4, GTR5, and GTR6 may be turned on when the off-voltage Voff or the on-voltage Von is applied.

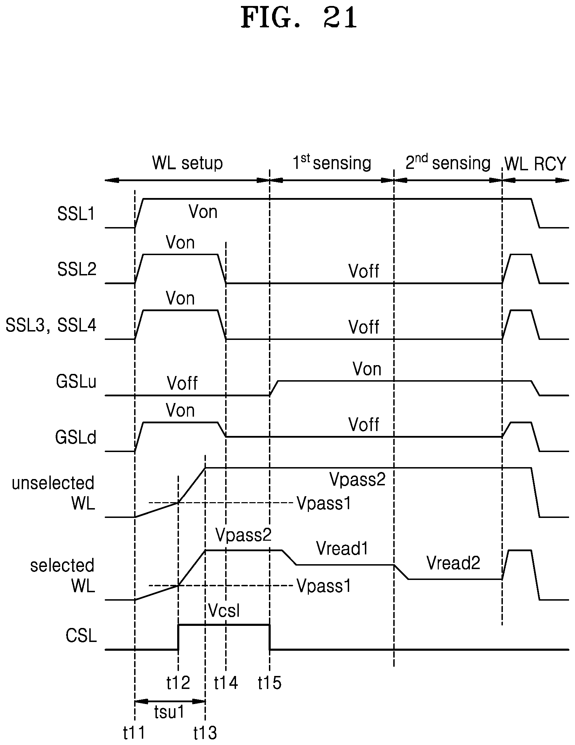

FIG. 21 is a timing diagram illustrating a sensing operation of a memory device, according to an embodiment. FIG. 21 may be described below with reference to FIGS. 19 and 20.

Referring to FIG. 21, the off-voltage Voff in FIG. 20 may be applied to the upper ground select line GSLu between the first time point t11 and the fifth time point t15. Since the off-voltage Voff is greater than the first threshold voltage Vth1 and lower than the second threshold voltage Vth2, the ground select transistors GTR1 and GTR2 may be turned off, and the ground select transistors GRT3 and GRT4 may be turned on.

The on-voltage Von in FIG. 20 is applied to the lower ground select line GSLd between the first time point t11 and the fourth time point t14. Since the on-voltage Von is greater than the second threshold voltage Vth2, the ground select transistors GTR5 to GTR8 may be turned on.

For example, the string C may be electrically connected to the common source line CSL between the first time point t11 and the fourth time point t14, and the string A and the string B may not be electrically connected to the common source line CSL. Thus, as described above with reference to FIG. 9A, the channel of the string C between the first time point t11 and the second time point t12 may be initialized in the direction of the common source line CSL. In addition, as described above with reference to FIG. 9B, the channel of the string C between the second time point t12 and the fourth time point t14 may be pre-charged in the direction of the common source line CSL. Coupled up with the voltage applied to the common source line CSL, the voltage levels of the selected and unselected word lines increase.

Since the off-voltage Voff is applied to the lower ground select line GSLd between the fourth time point t14 and the fifth time point t15, the strings A, B, and C may not be electrically connected to the common source line CSL.

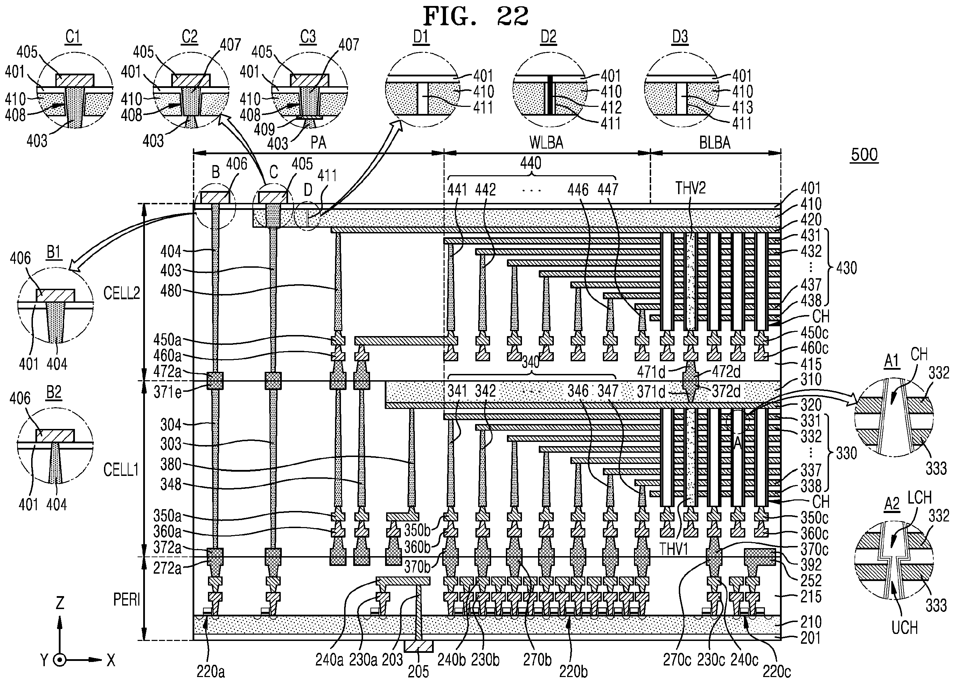

FIG. 22 is a view illustrating a memory device 500 according to some embodiments of the inventive concepts.

Referring to FIG. 22, the memory device 500 may have a chip-to-chip (C2C) structure. At least one upper chip including a cell region and a lower chip including a peripheral circuit region PERI may be manufactured separately, and then, the at least one upper chip and the lower chip may be connected to each other by a bonding method to realize the C2C structure. For example, the bonding method may mean a method of electrically or physically connecting a bonding metal pattern formed in an uppermost metal layer of the upper chip to a bonding metal pattern formed in an uppermost metal layer of the lower chip. For example, in a case in which the bonding metal patterns are formed of copper (Cu), the bonding method may be a Cu-Cu bonding method. Alternatively, the bonding metal patterns may be formed of aluminum (Al) or tungsten (W).

The memory device 500 may include the at least one upper chip including the cell region. For example, as illustrated in FIG. 22, the memory device 500 may include two upper chips. However, the number of the upper chips is not limited thereto. In the case in which the memory device 500 includes the two upper chips, a first upper chip including a first cell region CELL1, a second upper chip including a second cell region CELL2 and the lower chip including the peripheral circuit region PERI may be manufactured separately, and then, the first upper chip, the second upper chip and the lower chip may be connected to each other by the bonding method to manufacture the memory device 500. The first upper chip may be turned over and then may be connected to the lower chip by the bonding method, and the second upper chip may also be turned over and then may be connected to the first upper chip by the bonding method. Hereinafter, upper and lower portions of each of the first and second upper chips will be defined before each of the first and second upper chips is turned over. In other words, an upper portion of the lower chip may mean an upper portion defined based on a +Z-axis direction, and the upper portion of each of the first and second upper chips may mean an upper portion defined based on a -Z-axis direction in FIG. 22. However, embodiments of the inventive concepts are not limited thereto. In certain embodiments, one of the first upper chip and the second upper chip may be turned over and then may be connected to a corresponding chip by the bonding method.

Each of the peripheral circuit region PERI and the first and second cell regions CELL1 and CELL2 of the memory device 500 may include an external pad bonding region PA, a word line bonding region WLBA, and a bit line bonding region BLBA.

The peripheral circuit region PERI may include a first substrate 210 and a plurality of circuit elements 220a, 220b and 220c formed on the first substrate 210. An interlayer insulating layer 215 including one or more insulating layers may be provided on the plurality of circuit elements 220a, 220b and 220c, and a plurality of metal lines electrically connected to the plurality of circuit elements 220a, 220b and 220c may be provided in the interlayer insulating layer 215. For example, the plurality of metal lines may include first metal lines 230a, 230b and 230c connected to the plurality of circuit elements 220a, 220b and 220c, and second metal lines 240a, 240b and 240c formed on the first metal lines 230a, 230b and 230c. The plurality of metal lines may be formed of at least one of various conductive materials. For example, the first metal lines 230a, 230b and 230c may be formed of tungsten having a relatively high electrical resistivity, and the second metal lines 240a, 240b and 240c may be formed of copper having a relatively low electrical resistivity.

The first metal lines 230a, 230b and 230c and the second metal lines 240a, 240b and 240c are illustrated and described in the present embodiments. However, embodiments of the inventive concepts are not limited thereto. In certain embodiments, at least one or more additional metal lines may further be formed on the second metal lines 240a, 240b and 240c. In this case, the second metal lines 240a, 240b and 240c may be formed of aluminum, and at least some of the additional metal lines formed on the second metal lines 240a, 240b and 240c may be formed of copper having an electrical resistivity lower than that of aluminum of the second metal lines 240a, 240b and 240c.

The interlayer insulating layer 215 may be disposed on the first substrate 210 and may include an insulating material such as silicon oxide and/or silicon nitride.

Each of the first and second cell regions CELL1 and CELL2 may include at least one memory block. The first cell region CELL1 may include a second substrate 310 and a common source line 320. A plurality of word lines 330 (331 to 338) may be stacked on the second substrate 310 in a direction (i.e., the Z-axis direction) perpendicular to a top surface of the second substrate 310. String selection lines and a ground selection line may be disposed on and under the word lines 330, and the plurality of word lines 330 may be disposed between the string selection lines and the ground selection line. Likewise, the second cell region CELL2 may include a third substrate 410 and a common source line 420, and a plurality of word lines 430 (431 to 438) may be stacked on the third substrate 410 in a direction (i.e., the Z-axis direction) perpendicular to a top surface of the third substrate 410. Each of the second substrate 310 and the third substrate 410 may be formed of at least one of various materials and may be, for example, a silicon substrate, a silicon-germanium substrate, a germanium substrate, or a substrate having a single-crystalline epitaxial layer grown on a single-crystalline silicon substrate. A plurality of channel structures CH may be formed in each of the first and second cell regions CELL1 and CELL2.

In some embodiments, as illustrated in a region 'A1', the channel structure CH may be provided in the bit line bonding region BLBA and may extend in the direction perpendicular to the top surface of the second substrate 310 to penetrate the word lines 330, the string selection lines, and the ground selection line. The channel structure CH may include a data storage layer, a channel layer, and a filling insulation layer. The channel layer may be electrically connected to a first metal line 350c and a second metal line 360c in the bit line bonding region BLBA. For example, the second metal line 360c may be a bit line and may be connected to the channel structure CH through the first metal line 350c. The bit line 360c may extend in a first direction (e.g., a Y-axis direction) parallel to the top surface of the second substrate 310.

In some embodiments, as illustrated in a region 'A2', the channel structure CH may include a lower channel LCH and an upper channel UCH, which are connected to each other. For example, the channel structure CH may be formed by a process of forming the lower channel LCH and a process of forming the upper channel UCH. The lower channel LCH may extend in the direction perpendicular to the top surface of the second substrate 310 to penetrate the common source line 320 and lower word lines 331 and 332. The lower channel LCH may include a data storage layer, a channel layer, and a filling insulation layer and may be connected to the upper channel UCH. The upper channel UCH may penetrate upper word lines 333 to 338. The upper channel UCH may include a data storage layer, a channel layer, and a filling insulation layer, and the channel layer of the upper channel UCH may be electrically connected to the first metal line 350c and the second metal line 360c. As a length of a channel increases, due to characteristics of manufacturing processes, it may be difficult to form a channel having a substantially uniform width. The memory device 500 according to the present embodiments may include a channel having improved width uniformity due to the lower channel LCH and the upper channel UCH which are formed by the processes performed sequentially.

In the case in which the channel structure CH includes the lower channel LCH and the upper channel UCH as illustrated in the region 'A2', a word line located near to a boundary between the lower channel LCH and the upper channel UCH may be a dummy word line. For example, the word lines 332 and 333 adjacent to the boundary between the lower channel LCH and the upper channel UCH may be the dummy word lines. In this case, data may not be stored in memory cells connected to the dummy word line. Alternatively, the number of pages corresponding to the memory cells connected to the dummy word line may be less than the number of pages corresponding to the memory cells connected to a general word line. A level of a voltage applied to the dummy word line may be different from a level of a voltage applied to the general word line, and thus it is possible to reduce an influence of a non-uniform channel width between the lower and upper channels LCH and UCH on an operation of the memory device.

Meanwhile, the number of the lower word lines 331 and 332 penetrated by the lower channel LCH is less than the number of the upper word lines 333 to 338 penetrated by the upper channel UCH in the region 'A2'. However, embodiments of the inventive concepts are not limited thereto. In certain embodiments, the number of the lower word lines penetrated by the lower channel LCH may be equal to or more than the number of the upper word lines penetrated by the upper channel UCH. In addition, structural features and connection relation of the channel structure CH disposed in the second cell region CELL2 may be substantially the same as those of the channel structure CH disposed in the first cell region CELL1.

In the bit line bonding region BLBA, a first through-electrode THV1 may be provided in the first cell region CELL1, and a second through-electrode THV2 may be provided in the second cell region CELL2. As illustrated in FIG. 22, the first through-electrode THV1 may penetrate the common source line 320 and the plurality of word lines 330. In certain embodiments, the first through-electrode THV1 may further penetrate the second substrate 310. The first through-electrode THV1 may include a conductive material. Alternatively, the first through-electrode THV1 may include a conductive material surrounded by an insulating material. The second through-electrode THV2 may have the same shape and structure as the first through-electrode THV1.

In some embodiments, the first through-electrode THV1 and the second through-electrode THV2 may be electrically connected to each other through a first through-metal pattern 372d and a second through-metal pattern 472d. The first through-metal pattern 372d may be formed at a bottom end of the first upper chip including the first cell region CELL1, and the second through-metal pattern 472d may be formed at a top end of the second upper chip including the second cell region CELL2. The first through-electrode THV1 may be electrically connected to the first metal line 350c and the second metal line 360c. A lower via 371d may be formed between the first through-electrode THV1 and the first through-metal pattern 372d, and an upper via 471d may be formed between the second through-electrode THV2 and the second through-metal pattern 472d. The first through-metal pattern 372d and the second through-metal pattern 472d may be connected to each other by the bonding method.

In addition, in the bit line bonding region BLBA, an upper metal pattern 252 may be formed in an uppermost metal layer of the peripheral circuit region PERI, and an upper metal pattern 392 having the same shape as the upper metal pattern 252 may be formed in an uppermost metal layer of the first cell region CELL1. The upper metal pattern 392 of the first cell region CELL1 and the upper metal pattern 252 of the peripheral circuit region PERI may be electrically connected to each other by the bonding method. In the bit line bonding region BLBA, the bit line 360c may be electrically connected to a page buffer included in the peripheral circuit region PERI. For example, some of the circuit elements 220c of the peripheral circuit region PERI may constitute the page buffer, and the bit line 360c may be electrically connected to the circuit elements 220c constituting the page buffer through an upper bonding metal pattern 370c of the first cell region CELL1 and an upper bonding metal pattern 270c of the peripheral circuit region PERI.

Referring continuously to FIG. 22, in the word line bonding region WLBA, the word lines 330 of the first cell region CELL1 may extend in a second direction (e.g., an X-axis direction) parallel to the top surface of the second substrate 310 and may be connected to a plurality of cell contact plugs 340 (341 to 347). First metal lines 350b and second metal lines 360b may be sequentially connected onto the cell contact plugs 340 connected to the word lines 330. In the word line bonding region WLBA, the cell contact plugs 340 may be connected to the peripheral circuit region PERI through upper bonding metal patterns 370b of the first cell region CELL1 and upper bonding metal patterns 270b of the peripheral circuit region PERI.

The cell contact plugs 340 may be electrically connected to a row decoder included in the peripheral circuit region PERI. For example, some of the circuit elements 220b of the peripheral circuit region PERI may constitute the row decoder, and the cell contact plugs 340 may be electrically connected to the circuit elements 220b constituting the row decoder through the upper bonding metal patterns 370b of the first cell region CELL1 and the upper bonding metal patterns 270b of the peripheral circuit region PERI. In some embodiments, an operating voltage of the circuit elements 220b constituting the row decoder may be different from an operating voltage of the circuit elements 220c constituting the page buffer. For example, the operating voltage of the circuit elements 220c constituting the page buffer may be greater than the operating voltage of the circuit elements 220b constituting the row decoder.

Likewise, in the word line bonding region WLBA, the word lines 430 of the second cell region CELL2 may extend in the second direction (e.g., the X-axis direction) parallel to the top surface of the third substrate 410 and may be connected to a plurality of cell contact plugs 440 (441 to 447). The cell contact plugs 440 may be connected to the peripheral circuit region PERI through an upper metal pattern of the second cell region CELL2 and lower and upper metal patterns and a cell contact plug 348 of the first cell region CELL1.

In the word line bonding region WLBA, the upper bonding metal patterns 370b may be formed in the first cell region CELL1, and the upper bonding metal patterns 270b may be formed in the peripheral circuit region PERI. The upper bonding metal patterns 370b of the first cell region CELL1 and the upper bonding metal patterns 270b of the peripheral circuit region PERI may be electrically connected to each other by the bonding method. The upper bonding metal patterns 370b and the upper bonding metal patterns 270b may be formed of aluminum, copper, or tungsten.

In the external pad bonding region PA, a lower metal pattern 371e may be formed in a lower portion of the first cell region CELL1, and an upper metal pattern 472a may be formed in an upper portion of the second cell region CELL2. The lower metal pattern 371e of the first cell region CELL1 and the upper metal pattern 472a of the second cell region CELL2 may be connected to each other by the bonding method in the external pad bonding region PA. Likewise, an upper metal pattern 372a may be formed in an upper portion of the first cell region CELL1, and an upper metal pattern 272a may be formed in an upper portion of the peripheral circuit region PERI. The upper metal pattern 372a of the first cell region CELL1 and the upper metal pattern 272a of the peripheral circuit region PERI may be connected to each other by the bonding method.

Common source line contact plugs 380 and 480 may be disposed in the external pad bonding region PA. The common source line contact plugs 380 and 480 may be formed of a conductive material such as a metal, a metal compound, and/or doped polysilicon. The common source line contact plug 380 of the first cell region CELL1 may be electrically connected to the common source line 320, and the common source line contact plug 480 of the second cell region CELL2 may be electrically connected to the common source line 420. A first metal line 350a and a second metal line 360a may be sequentially stacked on the common source line contact plug 380 of the first cell region CELL1, and a first metal line 450a and a second metal line 460a may be sequentially stacked on the common source line contact plug 480 of the second cell region CELL2.

Input/output pads 205, 405 and 406 may be disposed in the external pad bonding region PA. Referring to FIG. 22, a lower insulating layer 201 may cover a bottom surface of the first substrate 210, and a first input/output pad 205 may be formed on the lower insulating layer 201. The first input/output pad 205 may be connected to at least one of a plurality of the circuit elements 220a disposed in the peripheral circuit region PERI through a first input/output contact plug 203 and may be separated from the first substrate 210 by the lower insulating layer 201. In addition, a side insulating layer may be disposed between the first input/output contact plug 203 and the first substrate 210 to electrically isolate the first input/output contact plug 203 from the first substrate 210.

An upper insulating layer 401 covering a top surface of the third substrate 410 may be formed on the third substrate 410. A second input/output pad 405 and/or a third input/output pad 406 may be disposed on the upper insulating layer 401. The second input/output pad 405 may be connected to at least one of the plurality of circuit elements 220a disposed in the peripheral circuit region PERI through second input/output contact plugs 403 and 303, and the third input/output pad 406 may be connected to at least one of the plurality of circuit elements 220a disposed in the peripheral circuit region PERI through third input/output contact plugs 404 and 304.

In some embodiments, the third substrate 410 may not be disposed in a region in which the input/output contact plug is disposed. For example, as illustrated in a region 'B', the third input/output contact plug 404 may be separated from the third substrate 410 in a direction parallel to the top surface of the third substrate 410 and may penetrate an interlayer insulating layer 415 of the second cell region CELL2 so as to be connected to the third input/output pad 406. In this case, the third input/output contact plug 404 may be formed by at least one of various processes.

In some embodiments, as illustrated in a region 'B1', the third input/output contact plug 404 may extend in a third direction (e.g., the Z-axis direction), and a diameter of the third input/output contact plug 404 may become progressively greater toward the upper insulating layer 401. In other words, a diameter of the channel structure CH described in the region 'A1' may become progressively less toward the upper insulating layer 401, but the diameter of the third input/output contact plug 404 may become progressively greater toward the upper insulating layer 401. For example, the third input/output contact plug 404 may be formed after the second cell region CELL2 and the first cell region CELL1 are bonded to each other by the bonding method.

In certain embodiments, as illustrated in a region 'B2', the third input/output contact plug 404 may extend in the third direction (e.g., the Z-axis direction), and a diameter of the third input/output contact plug 404 may become progressively less toward the upper insulating layer 401. In other words, like the channel structure CH, the diameter of the third input/output contact plug 404 may become progressively less toward the upper insulating layer 401. For example, the third input/output contact plug 404 may be formed together with the cell contact plugs 440 before the second cell region CELL2 and the first cell region CELL1 are bonded to each other.

In certain embodiments, the input/output contact plug may overlap with the third substrate 410. For example, as illustrated in a region 'C', the second input/output contact plug 403 may penetrate the interlayer insulating layer 415 of the second cell region CELL2 in the third direction (e.g., the Z-axis direction) and may be electrically connected to the second input/output pad 405 through the third substrate 410. In this case, a connection structure of the second input/output contact plug 403 and the second input/output pad 405 may be realized by various methods.

In some embodiments, as illustrated in a region 'C1', an opening 408 may be formed to penetrate the third substrate 410, and the second input/output contact plug 403 may be connected directly to the second input/output pad 405 through the opening 408 formed in the third substrate 410. In this case, as illustrated in the region 'C1', a diameter of the second input/output contact plug 403 may become progressively greater toward the second input/output pad 405. However, embodiments of the inventive concepts are not limited thereto, and in certain embodiments, the diameter of the second input/output contact plug 403 may become progressively less toward the second input/output pad 405.

In certain embodiments, as illustrated in a region 'C2', the opening 408 penetrating the third substrate 410 may be formed, and a contact 407 may be formed in the opening 408. An end of the contact 407 may be connected to the second input/output pad 405, and another end of the contact 407 may be connected to the second input/output contact plug 403. Thus, the second input/output contact plug 403 may be electrically connected to the second input/output pad 405 through the contact 407 in the opening 408. In this case, as illustrated in the region 'C2', a diameter of the contact 407 may become progressively greater toward the second input/output pad 405, and a diameter of the second input/output contact plug 403 may become progressively less toward the second input/output pad 405. For example, the second input/output contact plug 403 may be formed together with the cell contact plugs 440 before the second cell region CELL2 and the first cell region CELL1 are bonded to each other, and the contact 407 may be formed after the second cell region CELL2 and the first cell region CELL1 are bonded to each other.

In certain embodiments illustrated in a region 'C3', a stopper 409 may further be formed on a bottom end of the opening 408 of the third substrate 410, as compared with the embodiments of the region 'C2'. The stopper 409 may be a metal line formed in the same layer as the common source line 420. Alternatively, the stopper 409 may be a metal line formed in the same layer as at least one of the word lines 430. The second input/output contact plug 403 may be electrically connected to the second input/output pad 405 through the contact 407 and the stopper 409.

Like the second and third input/output contact plugs 403 and 404 of the second cell region CELL2, a diameter of each of the second and third input/output contact plugs 303 and 304 of the first cell region CELL1 may become progressively less toward the lower metal pattern 371e or may become progressively greater toward the lower metal pattern 371e.

Meanwhile, in some embodiments, a slit 411 may be formed in the third substrate 410. For example, the slit 411 may be formed at a certain position of the external pad bonding region PA. For example, as illustrated in a region 'D', the slit 411 may be located between the second input/output pad 405 and the cell contact plugs 440 when viewed in a plan view. Alternatively, the second input/output pad 405 may be located between the slit 411 and the cell contact plugs 440 when viewed in a plan view.

In some embodiments, as illustrated in a region 'D1', the slit 411 may be formed to penetrate the third substrate 410. For example, the slit 411 may be used to prevent the third substrate 410 from being finely cracked when the opening 408 is formed. However, embodiments of the inventive concepts are not limited thereto, and in certain embodiments, the slit 411 may be formed to have a depth ranging from about 60% to about 70% of a thickness of the third substrate 410.

In certain embodiments, as illustrated in a region 'D2', a conductive material 412 may be formed in the slit 411. For example, the conductive material 412 may be used to discharge a leakage current occurring in driving of the circuit elements in the external pad bonding region PA to the outside. In this case, the conductive material 412 may be connected to an external ground line.

In certain embodiments, as illustrated in a region 'D3', an insulating material 413 may be formed in the slit 411. For example, the insulating material 413 may be used to electrically isolate the second input/output pad 405 and the second input/output contact plug 403 disposed in the external pad bonding region PA from the word line bonding region WLBA. Since the insulating material 413 is formed in the slit 411, it is possible to prevent a voltage provided through the second input/output pad 405 from affecting a metal layer disposed on the third substrate 410 in the word line bonding region WLBA.

Meanwhile, in certain embodiments, the first to third input/output pads 205, 405 and 406 may be selectively formed. For example, the memory device 500 may be realized to include only the first input/output pad 205 disposed on the first substrate 210, to include only the second input/output pad 405 disposed on the third substrate 410, or to include only the third input/output pad 406 disposed on the upper insulating layer 401.

In some embodiments, at least one of the second substrate 310 of the first cell region CELL1 or the third substrate 410 of the second cell region CELL2 may be used as a sacrificial substrate and may be completely or partially removed before or after a bonding process. An additional layer may be stacked after the removal of the substrate. For example, the second substrate 310 of the first cell region CELL1 may be removed before or after the bonding process of the peripheral circuit region PERI and the first cell region CELL1, and then, an insulating layer covering a top surface of the common source line 320 or a conductive layer for connection may be formed. Likewise, the third substrate 410 of the second cell region CELL2 may be removed before or after the bonding process of the first cell region CELL1 and the second cell region CELL2, and then, the upper insulating layer 401 covering a top surface of the common source line 420 or a conductive layer for connection may be formed.

The memory cell array 30 of FIG. 1 may be disposed in the first cell region CELL1 and/or the second cell region CELL2. The peripheral circuit 40, 40' of FIG. 1, 10 may be disposed in the peripheral region PERI.

While aspects of the inventive concept have been particularly shown and described with reference to embodiments thereof, it will be understood that various changes in form and details may be made therein without departing from the scope of the following claims.

## Claims

1. A method of operating a memory device (1, 2) comprising a plurality of word lines (WL1 - WL8), a plurality of ground select lines (GSL1 - GSL3), a plurality of strings connected to a common source line (CSL), and a plurality of string select lines (SSL1 - SSL3) connected to the plurality of strings, wherein the plurality of word lines (WL1 - WL8) are connected to each string of the plurality of strings, the method comprising, during a word line setup period of a read or verification operation:
applying at a first time point, hereinafter termed t11, one of i) an on-voltage (Von) to an unselected ground select line (GSL2) and ii) a pre-charge voltage (Vcsl) to the common source line (CSL);
applying a pass voltage to a plurality of unselected word lines and a selected word line included in the plurality of word lines (WL1 - WL8) such that, at a second time point, hereinafter termed t12, the plurality of unselected word lines and the selected word line reach a first pass voltage (Vpass1);
applying at the second time point t12 the other one of i) the on-voltage (Von) to the unselected ground select line (GSL2) and ii) the pre-charge voltage (Vcsl) to the common source line (CSL);
increasing a voltage of the plurality of unselected word lines and the selected word line from the first pass voltage (Vpass1) by having simultaneously at the second time point the common source line (CSL) at the pre-charge voltage (Vcsl) and the unselected ground select line (GSL2) at the on-voltage (Von);
applying an off-voltage (Voff) to the unselected ground select line (GSL2) at a third time point, hereinafter termed t14; and
applying a ground voltage to the common source line (CSL) at a fourth time point, hereinafter termed t15,
wherein t11<t12<t14<t15.

2. The method of claim 1,
wherein a voltage rising slope of the plurality of unselected word lines and the selected word line is greater in a time period after the second time point t12 than in a time period before the second time point t12.

3. The method of claim 1 or 2, further comprising:
applying the on-voltage (Von) to a selected ground select line (GSL1) during a sensing period following the word line setup period;
applying a first read voltage (Vread1) to the selected word line during a first time period of the sensing period;
applying a second read voltage (Vread2) to the selected word line during a second time period of the sensing period; and
selectively applying the on-voltage (Von) to the unselected ground select line (GSL2) based on characteristics of the selected word line during the second time period.

4. The method of claim 3, wherein the characteristics of the selected word line include
at least one of a stacking position of the selected word line among the plurality of word lines, a width (w) of a channel hole for a channel (732) of the selected word line, a distance between the channel (732) and an end of the selected word line, a thickness (Ls) of an insulating layer (733) between the selected word line and the channel (732), and a voltage level applied to the selected word line during the sensing period.

5. The method of any preceding claim, further comprising:
applying the on-voltage (Von) to a selected string select line (SSL1, SSL2) and an unselected string select line (SSL3, SSL4) during the word line setup period.

6. The method of any one of claims 1 to 4, further comprising:
applying the on-voltage (Von) to a selected string select line (SSL1, SSL2) during the word line setup period; and
maintaining the voltage of an unselected string select line (SSL3, SSL4) at the off-voltage (Voff) during the word line setup period.

7. The method of any preceding claim, further comprising:
recovering the selected word line after applying a program voltage to the selected word line during a program period before the word line setup period;
recovering the selected word line after applying the on-voltage (Von) to a selected ground select line (GSL1) and the unselected ground select line (GSL2) during the program period; and
after applying the pre-charge voltage to the common source line (CSL) during the program period, maintaining the applied pre-charge voltage (Vcsl) until the fourth time point t15.

8. The method of any preceding claim,
wherein each of the plurality of strings comprises
a first transistor (GTR3, GTR4) connected to a first ground select line (GSLu) among the plurality of ground select lines and having a first threshold voltage (vth1), and
a second transistor (GTR7, GTR8) connected to a second ground select line (GSLd) among the plurality of ground select lines and having a second threshold voltage (vth2) higher than the first threshold voltage (vth1),
wherein the applying of the on-voltage (Von) to the unselected ground select line at the first time point t11 during the word line setup period comprises:
applying a voltage having a level between the first threshold voltage (vth1) and the second threshold voltage (vth2) to the first ground select line (GSLu), and
applying a voltage having a level equal to or higher than the second threshold voltage (vth2) to the second ground select line (GSLd).

9. The method of claim 8,
wherein the applying of the off-voltage (Voff) to the unselected ground select line at the third time point t14 during the word line setup period comprises:
maintaining the voltage of the first ground select line (GSLu) at the level between the first threshold voltage (vth1) and the second threshold voltage (vth2), and
applying the voltage having a level between the first threshold voltage (vth1) and the second threshold voltage (vth2) to the second ground select line (GSLd).

10. A memory device (1, 2) comprising:
a memory cell array (30) comprising a plurality of strings connected to a common source line (CSL);
a plurality of word lines (WL1 - WL8) connected to each string of the plurality of strings;
a plurality of ground select lines (GSL1 - GSL3) connected to the plurality of strings; and
a plurality of string select lines (SSL1 - SSL3) connected to the plurality of strings,
wherein the memory device is configured to enable, during a word line setup period of a read or verification operation:
application at a first time point, hereinafter termed t11, one of i) an on-voltage (Von) to an unselected ground select line (GSL2) and ii) a pre-charge voltage (Vcsl) to the common source line (CSL);
application of a pass voltage to a plurality of unselected word lines and a selected word line included in plurality of word lines (WL1 - WL8) such that, at a second time point, hereinafter termed t12, the plurality of unselected word lines and the selected word line reach a first pass voltage (Vpass1);
application at the second time point t12 the other one of i) the on-voltage (Von) to the unselected ground select line (GSL2) and ii) the pre-charge voltage (Vcsl) to the common source line (CSL);
increasing a voltage of the plurality of unselected word lines and the selected word line from the first pass voltage (Vpass1) by having simultaneously at the second time point the common source line (CSL) at the pre-charge voltage (Vcsl) and the unselected ground select line (GSL2) at the on-voltage (Von)
application of an off-voltage (Voff) to the unselected ground select line (GSL2) at a third time point, hereinafter termed t14; and
application of a ground voltage to the common source line (CSL) at a fourth time point, hereinafter termed t15,
wherein t11<t12<t14<t15.

11. The memory device of claim 10, wherein the memory device is configured to enable the voltage of the plurality of unselected word lines and the selected word line to be increased to a second pass voltage (Vpass2) higher than the first pass voltage (Vpass1) at a fifth time point, hereinafter termed t13, between the second time point t12 and the third time point t14.

12. The memory device of claim 10 or 11,
wherein the memory device is configured to enable a first read voltage (Vread1) to be applied to the selected word line during a first time period after the fourth time point t15, a second read voltage (Vread2) to be applied to the selected word line during a second time period after the first time period, and
the on-voltage (Von) to be applied to the unselected ground select line (GSL2) during the second time period based on characteristics of the selected word line.

13. The memory device of claim 12, wherein the characteristics of the selected word line include
at least one of a stacking position of the selected word line, a width (w) of a channel hole for a channel (732) of the selected word line, a distance between the channel (732) and an end of the selected word line, a thickness (Ls) of an insulating layer (733) between the selected word line and the channel (732), and a voltage level applied to the selected word line during the second time period.

14. The memory device of any one of claims 10 to 13, wherein the memory device is configured to enable at the first time point t11, the on-voltage (Von) to be applied to a string select line (SSL1, SSL2) connected to a string connected to a selected ground select line (GSL1), and the off-voltage (Voff) to be applied to a string select line (SSL3, SSL4) connected to a string connected to the unselected ground select line (GSL2).

15. The memory device of any one of claims 10 to 13, wherein, the memory device is configured to enable at the first time point t11, the on-voltage (Von) to be applied to a string select line (SSL1, SSL2) connected to a string connected to a selected ground select line (GSL1), and the on-voltage (Von) to be applied to a string select line (SSL3, SSL4) connected to a string connected to the unselected ground select line (GSL2).

## Patentansprüche

1. Verfahren zum Betreiben einer Speichervorrichtung (1, 2), die eine Vielzahl von Wortleitungen (WL1- WL8), eine Vielzahl von Masseauswahlleitungen (GSL1 - GSL3), eine Vielzahl von Strings, die mit einer gemeinsamen Source-Leitung (CSL) verbunden sind, und eine Vielzahl von Stringauswahlleitungen (SSL1 - SSL3) umfasst, die mit der Vielzahl von Strings verbunden sind, wobei die Vielzahl von Wortleitungen (WL1 - WL8) mit jedem String der Vielzahl von Strings verbunden ist, wobei das Verfahren während eines Wortleitungsaufbauzeitraums eines Lese- oder Verifizierungsvorgangs umfasst:
Anlegen zu einem ersten Zeitpunkt, im Folgenden t11 genannt, einer von i) einer Ein-Spannung (Von) an eine nicht ausgewählte Masseauswahlleitung (GSL2) oder ii) einer Vorladungsspannung (Vcs1) an die gemeinsame Source-Leitung (CSL);
Anlegen einer Durchgangsspannung an eine Vielzahl nicht ausgewählter Wortleitungen und eine ausgewählte Wortleitung, die in der Vielzahl von Wortleitungen (WL1 - WL8) beinhaltet sind, sodass zu einem zweiten Zeitpunkt, im Folgenden t12 genannt, die Vielzahl nicht ausgewählter Wortleitungen und die ausgewählte Wortleitung eine erste Durchgangsspannung (Vpass1) erreichen;
Anlegen zum zweiten Zeitpunkt t12 der anderen von i) der Ein-Spannung (Von) an die nicht ausgewählte Masseauswahlleitung (GSL2) und ii) der Vorladungsspannung (Vcs1) an die gemeinsame Source-Leitung (CSL);
Erhöhen einer Spannung der Vielzahl nicht ausgewählter Wortleitungen und der ausgewählten Wortleitung von der ersten Durchgangsspannung (Vpass1), indem zum zweiten Zeitpunkt gleichzeitig die gemeinsame Source-Leitung (CSL) die Vorladungsspannung (Vcs1) und die nicht ausgewählte Masseauswahlleitung (GSL2) die Ein-Spannung (Von) aufweisen;
Anlegen einer Aus-Spannung (Voff) an die nicht ausgewählte Masseauswahlleitung (GSL2) zu einem dritten Zeitpunkt, im Folgenden t14 genannt; und
Anlegen einer Massespannung an die gemeinsame Source-Leitung (CSL) zu einem vierten Zeitpunkt, im Folgenden t15 genannt,
wobei t11<t12<t14<t15.

2. Verfahren nach Anspruch 1,
wobei eine Spannungsanstiegsneigung der Vielzahl nicht ausgewählter Wortleitungen und der ausgewählten Wortleitung in einem Zeitraum nach dem zweiten Zeitpunkt t12 größer ist als in einem Zeitraum vor dem zweiten Zeitpunkt t12.

3. Verfahren nach Anspruch 1 oder 2, weiter umfassend:
Anlegen der Ein-Spannung (Von) an eine ausgewählte Masseauswahlleitung (GSL1) während eines Erfassungszeitraums nach dem Wortleitungsaufbauzeitraum;
Anlegen einer ersten Lesespannung (Vread1) an die ausgewählte Wortleitung während eines ersten Zeitraums des Erfassungszeitraums;
Anlegen einer zweiten Lesespannung (Vread2) an die ausgewählte Wortleitung während eines zweiten Zeitraums des Erfassungszeitraums; und
selektiv Anlegen der Ein-Spannung (Von) an die nicht ausgewählte Masseauswahlleitung (GSL2) basierend auf Eigenschaften der ausgewählten Wortleitung während des zweiten Zeitraums.

4. Verfahren nach Anspruch 3, wobei die Eigenschaften der ausgewählten Wortleitung beinhalten
mindestens eines von einer Stapelposition der ausgewählten Wortleitung aus der Vielzahl von Wortleitungen, einer Breite (w) eines Kanallochs für einen Kanal (732) der ausgewählten Wortleitung, einem Abstand zwischen dem Kanal (732) und einem Ende der ausgewählten Wortleitung, einer Dicke (Ls) einer Isolierschicht (733) zwischen der ausgewählten Wortleitung und dem Kanal (732) und einem Spannungspegel, der während des Erfassungszeitraums an die ausgewählte Wortleitung angelegt wird.

5. Verfahren nach einem vorstehenden Anspruch, weiter umfassend:
Anlegen der Ein-Spannung (Von) an eine ausgewählte Stringauswahlleitung (SSL1, SSL2) und eine nicht ausgewählte Stringauswahlleitung (SSL3, SSL4) während des Wortleitungsaufbauzeitraums.

6. Verfahren nach einem der Ansprüche 1 bis 4, weiter umfassend:
Anlegen der Ein-Spannung (Von) an eine ausgewählte Stringauswahlleitung (SSL1, SSL2) während des Wortleitungsaufbauzeitraums; und
Halten der Spannung einer nicht ausgewählten Stringauswahlleitung (SSL3, SSL4) auf der Aus-Spannung (Voff) während des Wortleitungsaufbauzeitraums.

7. Verfahren nach einem vorstehenden Anspruch, weiter umfassend:
Wiederherstellen der ausgewählten Wortleitung nach Anlegen einer Programmierspannung an die ausgewählte Wortleitung während eines Programmierzeitraums vor dem Wortleitungsaufbauzeitraum;
Wiederherstellen der ausgewählten Wortleitung nach Anlegen der Ein-Spannung (Von) an eine ausgewählte Masseauswahlleitung (GSL1) und die nicht ausgewählte Masseauswahlleitung (GSL2) während des Programmierzeitraums; und
nach Anlegen der Vorladungsspannung an die gemeinsame Source-Leitung (CSL) während des Programmierzeitraums, Aufrechterhalten der angelegten Vorladungsspannung (Vcs1) bis zum vierten Zeitpunkt t15.

8. Verfahren nach einem vorstehenden Anspruch, wobei jede der Vielzahl von Strings umfasst
einen ersten Transistor (GTR3, GTR4), der mit einer ersten Masseauswahlleitung (GSLu) aus der Vielzahl von Masseauswahlleitungen verbunden ist und eine erste Schwellenspannung (vth1) aufweist, und
einen zweiten Transistor (GTR7, GTR8), der mit einer zweiten Masseauswahlleitung (GSLd) aus der Vielzahl von Masseauswahlleitungen verbunden ist und eine zweite Schwellenspannung (vth2) aufweist, die höher ist als die erste Schwellenspannung (vth1),
wobei das Anlegen der Ein-Spannung (Von) an die nicht ausgewählte Masseauswahlleitung zum ersten Zeitpunkt t11 während des Wortleitungsaufbauzeitraums umfasst:
Anlegen einer Spannung, die einen Pegel zwischen der ersten Schwellenspannung (vth1) und der zweiten Schwellenspannung (vth2) aufweist, an die erste Masseauswahlleitung (GSLu), und
Anlegen einer Spannung, die einen Pegel gleich oder höher als die zweite Schwellenspannung (vth2) aufweist, an die zweite Masseauswahlleitung (GSLd).

9. Verfahren nach Anspruch 8,
wobei das Anlegen der Aus-Spannung (Voff) an die nicht ausgewählte Masseauswahlleitung zum dritten Zeitpunkt t14 während des Wortleitungsaufbauzeitraums umfasst:
Halten der Spannung der ersten Masseauswahlleitung (GSLu) auf dem Pegel zwischen der ersten Schwellenspannung (vth1) und der zweiten Schwellenspannung (vth2), und
Anlegen der Spannung, die einen Pegel zwischen der ersten Schwellenspannung (vth1) und der zweiten Schwellenspannung (vth2) aufweist, an die zweite Masseauswahlleitung (GSLd).

10. Speichervorrichtung (1,2), umfassend:
ein Speicherzellen-Array (30), das eine Vielzahl von Strings umfasst, die mit einer gemeinsamen Source-Leitung (CSL) verbunden sind;
eine Vielzahl von Wortleitungen (WL1 - WL8), die mit jedem String der Vielzahl von Strings verbunden sind;
eine Vielzahl von Masseauswahlleitungen (GSL1 - GSL3), die mit der Vielzahl von Strings verbunden sind; und
eine Vielzahl von Stringauswahlleitungen (SSL1 - SSL3), die mit der Vielzahl von Strings verbunden sind, wobei die Speichervorrichtung konfiguriert ist, um während eines Wortleitungsaufbauzeitraums eines Lese- oder Verifizierungsvorgangs zu ermöglichen:
Anlegung zu einem ersten Zeitpunkt, im Folgenden t11 genannt, einer von i) einer Ein-Spannung (Von) an eine nicht ausgewählte Masseauswahlleitung (GSL2) oder ii) einer Vorladungsspannung (Vcs1) an die gemeinsame Source-Leitung (CSL);
Anlegung einer Durchgangsspannung an eine Vielzahl nicht ausgewählter Wortleitungen und eine ausgewählte Wortleitung, die in einer Vielzahl von Wortleitungen (WL1 - WL8) beinhaltet sind, sodass zu einem zweiten Zeitpunkt, im Folgenden t12 genannt, die Vielzahl nicht ausgewählter Wortleitungen und die ausgewählte Wortleitung eine erste Durchgangsspannung (Vpass1) erreichen;
Anlegung zum zweiten Zeitpunkt t12 der anderen von i) der Ein-Spannung (Von) an die nicht ausgewählte Masseauswahlleitung (GSL2) und ii) der Vorladungsspannung (Vcs1) an die gemeinsame Source-Leitung (CSL);
Erhöhen einer Spannung der Vielzahl nicht ausgewählter Wortleitungen und der ausgewählten Wortleitung von der ersten Durchgangsspannung (Vpass1), indem zum zweiten Zeitpunkt gleichzeitig die gemeinsame Source-Leitung (CSL) die Vorladungsspannung (Vcs1) und die nicht ausgewählte Masseauswahlleitung (GSL2) die Ein-Spannung (Von) aufweisen
Anlegung einer Aus-Spannung (Voff) an die nicht ausgewählte Masseauswahlleitung (GSL2) zu einem dritten Zeitpunkt, im Folgenden t14 genannt; und
Anlegung einer Massespannung an die gemeinsame Source-Leitung (CSL) zu einem vierten Zeitpunkt, im Folgenden t15 genannt,
wobei t11<t12<t14<t15.

11. Speichervorrichtung nach Anspruch 10, wobei die Speichervorrichtung konfiguriert ist, um zu einem fünften Zeitpunkt, im Folgenden t13 genannt, zwischen dem zweiten Zeitpunkt t12 und dem dritten Zeitpunkt t14 eine Erhöhung der Spannung der Vielzahl von nicht ausgewählten Wortleitungen und der ausgewählten Wortleitung auf eine zweite Durchgangsspannung (Vpass2) zu ermöglichen, die höher ist als die erste Durchgangsspannung (Vpass1).

12. Speichervorrichtung nach Anspruch 10 oder 11,
wobei die Speichervorrichtung konfiguriert ist, um zu ermöglichen, dass eine erste Lesespannung (Vread1) an die ausgewählte Wortleitung während eines ersten Zeitraums nach dem vierten Zeitpunkt t15 angelegt wird, eine zweite Lesespannung (Vread2) an die ausgewählte Wortleitung während eines zweiten Zeitraums nach dem ersten Zeitraum angelegt wird und
die Ein-Spannung (Von) während des zweiten Zeitraums an die nicht ausgewählte Masseauswahlleitung (GSL2) basierend auf den Eigenschaften der ausgewählten Wortleitung angelegt wird.

13. Speichervorrichtung nach Anspruch 12, wobei die Eigenschaften der ausgewählten Wortleitung beinhalten
mindestens eines von einer Stapelposition der ausgewählten Wortleitung, einer Breite (w) eines Kanallochs für einen Kanal (732) der ausgewählten Wortleitung, einem Abstand zwischen dem Kanal (732) und einem Ende der ausgewählten Wortleitung, einer Dicke (Ls) einer Isolierschicht (733) zwischen der ausgewählten Wortleitung und dem Kanal (732) und einem Spannungspegel, der während des zweiten Zeitraums an die ausgewählte Wortleitung angelegt wird.

14. Speichervorrichtung nach einem der Ansprüche 10 bis 13, wobei die Speichervorrichtung konfiguriert ist, um zum ersten Zeitpunkt t11 zu ermöglichen, dass die Ein-Spannung (Von) an eine Stringauswahlleitung (SSL1, SSL2) angelegt wird, die mit einem String verbunden ist, der mit einer ausgewählten Masseauswahlleitung (GSL1) verbunden ist, und dass die Aus-Spannung (Voff) an eine Stringauswahlleitung (SSL3, SSL4) angelegt wird, die mit einem String verbunden ist, der mit der nicht ausgewählten Masseauswahlleitung (GSL2) verbunden ist.

15. Speichervorrichtung nach einem der Ansprüche 10 bis 13, wobei die Speichervorrichtung konfiguriert ist, um zum ersten Zeitpunkt t11 zu ermöglichen, dass die Ein-Spannung (Von) an eine Stringauswahlleitung (SSL1, SSL2) angelegt wird, die mit einem String verbunden ist, der mit einer ausgewählten Masseauswahlleitung (GSL1) verbunden ist, und dass die Ein-Spannung (Von) an eine Stringauswahlleitung (SSL3, SSL4) angelegt wird, die mit einem String verbunden ist, der mit der nicht ausgewählten Masseauswahlleitung (GSL2) verbunden ist.

## Revendications

1. Procédé de fonctionnement d'un dispositif de mémoire (1, 2) comprenant une pluralité de lignes de mots (WL1 - WL8), une pluralité de lignes de sélection de masse (GSL1 - GSL3), une pluralité de chaînes raccordées à une ligne de source commune (CSL) et une pluralité de lignes de sélection de chaîne (SSL1 - SSL3) raccordées à la pluralité de chaînes, dans lequel la pluralité de lignes de mots (WL1 - WL8) sont raccordées à chaque chaîne de la pluralité de chaînes, le procédé comprenant, pendant une période de configuration de ligne de mots d'une opération de lecture ou de vérification :
l'application à un premier instant, ci-après appelé t11, de l'une : i) d'une tension à l'état passant (Von) à une ligne de sélection de masse non sélectionnée (GSL2) et ii) d'une tension de précharge (Vcs1) à la ligne de source commune (CSL) ;
l'application d'une tension de passage à une pluralité de lignes de mots non sélectionnées et à une ligne de mots sélectionnée incluse dans la pluralité de lignes de mots (WL1 - WL8) de telle sorte que, à un deuxième instant, ci-après appelé t12, la pluralité de lignes de mots non sélectionnées et la ligne de mots sélectionnée atteignent une première tension de passage (Vpass1) ;
l'application, au deuxième instant t12, de l'autre i) de la tension à l'état passant (Von) à la ligne de sélection de masse non sélectionnée (GSL2) et ii) de la tension de précharge (Vcs1) à la ligne de source commune (CSL) ;
l'augmentation d'une tension de la pluralité de lignes de mots non sélectionnées et de la ligne de mots sélectionnée à partir de la première tension de passage (Vpass1) en présentant simultanément, au deuxième instant, la ligne de source commune (CSL) à la tension de précharge (Vcs1) et la ligne de sélection de masse non sélectionnée (GSL2) à la tension à l'état passant (Von) ;
l'application d'une tension à l'état bloqué (Voff) à la ligne de sélection de masse non sélectionnée (GSL2) à un troisième instant, ci-après appelé t14; et
l'application d'une tension de masse à la ligne de source commune (CSL) à un quatrième instant, ci-après appelé t15,
dans lequel t11 < t12 < t14 < t15.

2. Procédé selon la revendication 1,
dans lequel une pente de montée de tension de la pluralité de lignes de mots non sélectionnées et de la ligne de mots sélectionnée est plus importante pendant une période de temps après le deuxième instant tl2 que dans une période de temps avant le second instant t12.

3. Procédé selon la revendication 1 ou 2, comprenant en outre :
l'application de la tension à l'état passant (Von) à une ligne de sélection de masse sélectionnée (GSL1) pendant une période de détection après la période de configuration de ligne de mots ;
l'application d'une première tension de lecture (Vread1) à la ligne de mots sélectionnée pendant une première période de temps de la période de détection ;
l'application d'une seconde tension de lecture (Vread2) à la ligne de mots sélectionnée pendant une seconde période de temps de la période de détection ; et
l'application sélective de la tension à l'état passant (Von) à la ligne de sélection de masse non sélectionnée (GSL2) sur la base de caractéristiques de la ligne de mot sélectionnée pendant la seconde période de temps.

4. Procédé selon la revendication 3, dans lequel les caractéristiques de la ligne de mots sélectionnée incluent
au moins un d'une position d'empilement de la ligne de mots sélectionnée parmi la pluralité de lignes de mots, d'une largeur (w) d'un trou de canal pour un canal (732) de la ligne de mots sélectionnée, d'une distance entre le canal (732) et une extrémité de la ligne de mots sélectionnée, d'une épaisseur (Ls) d'une couche isolante (733) entre la ligne de mots sélectionnée et le canal (732), et d'un niveau de tension appliqué à la ligne de mots sélectionnée pendant la période de détection.

5. Procédé selon une quelconque revendication précédente, comprenant en outre :
l'application de la tension à l'état passant (Von) à une ligne de sélection de chaîne sélectionnée (SSL1, SSL2) et à une ligne de sélection de chaîne non sélectionnée (SSL3, SSL4) pendant la période de configuration de ligne de mots.

6. Procédé selon l'une quelconque des revendications 1 à 4, comprenant en outre :
l'application de la tension à l'état passant (Von) à une ligne de sélection de chaîne sélectionnée (SSL1, SSL2) pendant la période de configuration de ligne de mots ; et
le maintien de la tension d'une ligne de sélection de chaîne non sélectionnée (SSL3, SSL4) à la tension à l'état bloqué (Voff) pendant la période de configuration de ligne de mots.

7. Procédé selon une quelconque revendication précédente, comprenant en outre :
la récupération de la ligne de mots sélectionnée après avoir appliqué une tension de programme à la ligne de mots sélectionnée pendant une période de programme avant la période de configuration de la ligne de mots ;
la récupération de la ligne de mots sélectionnée après l'application de la tension à l'état passant (Von) à une ligne de sélection de masse sélectionnée (GSL1) et à la ligne de sélection de masse non sélectionnée (GSL2) pendant la période du programme ; et
après l'application de la tension de précharge à la ligne de source commune (CSL) pendant la période du programme, le maintien de la tension de précharge appliquée (Vcs1) jusqu'au quatrième instant t15.

8. Procédé selon une quelconque revendication précédente, dans lequel chaque chaîne de la pluralité de chaînes comprend
un premier transistor (GTR3, GTR4) raccordé à une première ligne de sélection de masse (GSLu) parmi la pluralité de lignes de sélection de masse et présentant une première tension de seuil (vth1), et
un second transistor (GTR7, GTR8) raccordé à une seconde ligne de sélection de masse (GSLd) parmi la pluralité de lignes de sélection de masse et présentant une seconde tension de seuil (vth2) plus élevée que la première tension de seuil (vth1),
dans lequel l'application de la tension à l'état passant (Von) à la ligne de sélection de masse non sélectionnée au premier instant t11 pendant la période de configuration de ligne de mots comprend :
l'application d'une tension présentant un niveau compris entre la première tension de seuil (vth1) et la seconde tension de seuil (vth2) à la première ligne de sélection de masse (GSLu), et
l'application d'une tension présentant un niveau égal ou supérieur à la seconde tension de seuil (vth2) à la seconde ligne de sélection de masse (GSLd).

9. Procédé selon la revendication 8,
dans lequel l'application de la tension à l'état bloqué (Voff) à la ligne de sélection de masse non sélectionnée au troisième instant t14 pendant la période de configuration de ligne de mots comprend :
le maintien de la tension de la première ligne de sélection de masse (GSLu) au niveau compris entre la première tension de seuil (vth1) et la seconde tension de seuil (vth2), et
l'application de la tension présentant un niveau compris entre la première tension de seuil (vth1) et la seconde tension de seuil (vth2) à la seconde ligne de sélection de masse (GSLd).

10. Dispositif de mémoire (1,2) comprenant :
un réseau de cellules de mémoire (30) comprenant une pluralité de chaînes raccordées à une ligne de source commune (CSL) ;
une pluralité de lignes de mots (WL1 - WL8) raccordées à chaque chaîne de la pluralité de chaînes ;
une pluralité de lignes de sélection de masse (GSL1 - GSL3) raccordées à la pluralité de chaînes ; et
une pluralité de lignes de sélection de chaîne (SSL1 - SSL3) raccordées à la pluralité de chaînes, dans lequel le dispositif de mémoire est configuré pour activer, pendant une période de configuration de ligne de mots d'une opération de lecture ou de vérification :
l'application, à un premier instant, ci-après appelé t11, de l'une : i) d'une tension à l'état passant (Von) à une ligne de sélection de masse non sélectionnée (GSL2) et ii) d'une tension de précharge (Vcs1) à la ligne de source commune (CSL) ;
l'application d'une tension de passage à une pluralité de lignes de mots non sélectionnées et à une ligne de mots sélectionnée incluse dans la pluralité de lignes de mots (WL1 - WL8) de telle sorte que, à un deuxième instant, ci-après appelé t12, la pluralité de lignes de mots non sélectionnées et la ligne de mots sélectionnée atteignent une première tension de passage (Vpass1) ;
l'application, au deuxième instant t12, de l'autre i) de la tension à l'état passant (Von) à la ligne de sélection de masse non sélectionnée (GSL2) et ii) de la tension de précharge (Vcs1) à la ligne de source commune (CSL) ;
l'augmentation d'une tension de la pluralité de lignes de mots non sélectionnées et de la ligne de mots sélectionnée à partir de la première tension de passage (Vpass1) en présentant simultanément, au deuxième instant, la ligne de source commune (CSL) à la tension de précharge (Vcs1) et la ligne de sélection de masse non sélectionnée (GSL2) à la tension à l'état passant (Von)
l'application d'une tension à l'état bloqué (Voff) à la ligne de sélection de masse non sélectionnée (GSL2) à un troisième instant, ci-après appelé t14 ; et
l'application d'une tension de masse à la ligne de source commune (CSL) à un quatrième instant, ci-après appelé t15,
dans lequel t11 < t12 < t14 < t15.

11. Dispositif de mémoire selon la revendication 10, dans lequel le dispositif de mémoire est configuré pour permettre l'augmentation de la tension de la pluralité de lignes de mots non sélectionnées et de la ligne de mots sélectionnée jusqu'à une seconde tension de passage (Vpass2) plus élevée que la première tension de passage (Vpass1) à un cinquième instant, ci-après appelé t13, entre le deuxième instant t12 et le troisième instant t14.

12. Dispositif de mémoire selon la revendication 10 ou 11,
dans lequel le dispositif de mémoire est configuré pour permettre l'application d'une première tension de lecture (Vread1) à la ligne de mots sélectionnée pendant une première période de temps après le quatrième point temporel t15, l'application d'une seconde tension de lecture (Vread2) à la ligne de mots sélectionnée pendant une seconde période de temps après la première période de temps, et
l'application de la tension à l'état passant (Von) à la ligne de sélection de masse non sélectionnée (GSL2) pendant la seconde période de temps sur la base de caractéristiques de la ligne de mots sélectionnée.

13. Dispositif de mémoire selon la revendication 12, dans lequel les caractéristiques de la ligne de mots sélectionnée incluent
au moins l'un d'une position d'empilement de la ligne de mots sélectionnée, d'une largeur (w) d'un trou de canal pour un canal (732) de la ligne de mots sélectionnée, d'une distance entre le canal (732) et une extrémité de la ligne de mots sélectionnée, d'une épaisseur (Ls) d'une couche isolante (733) entre la ligne de mots sélectionnée et le canal (732), et d'un niveau de tension appliqué à la ligne de mots sélectionnée pendant la seconde période de temps.

14. Dispositif de mémoire selon l'une quelconque des revendications 10 à 13, dans lequel le dispositif de mémoire est configuré pour permettre, au premier instant t11, l'application de la tension à l'état passant (Von) à une ligne de sélection de chaîne (SSL1, SSL2) raccordée à une chaîne raccordée à une ligne de sélection de masse sélectionnée (GSL1), et l'application de la tension à l'état bloqué (Voff) à une ligne de sélection de chaîne (SSL3, SSL4) raccordée à une chaîne raccordée à la ligne de sélection de masse non sélectionnée (GSL2).

15. Dispositif de mémoire selon l'une quelconque des revendications 10 à 13, dans lequel le dispositif de mémoire est configuré pour permettre, au premier instant t11, l'application de la tension à l'état passant (Von) à une ligne de sélection de chaîne (SSL1, SSL2) raccordée à une chaîne raccordée à une ligne de sélection de masse sélectionnée (GSL1), et l'application de la tension à l'état passant (Von) à une ligne de sélection de chaîne (SSL3, SSL4) raccordée à une chaîne raccordée à la ligne de sélection de masse non sélectionnée (GSL2).
